(19) Europäisches Patentamt / European Patent Office / Office européen des brevets

(11) **EP 3 979 300 A1**

(12) **EUROPEAN PATENT APPLICATION**
published in accordance with Art. 153(4) EPC

(43) Date of publication:
06.04.2022 Bulletin 2022/14

(21) Application number: 20812813.2

(22) Date of filing: 20.05.2020

(51) International Patent Classification (IPC):
*H01L 21/301* (2006.01)

(52) Cooperative Patent Classification (CPC):
(C-Sets available)
**H01L 24/27; H01L 21/6836; H01L 24/29;
H01L 24/83;** H01L 21/78; H01L 24/32;
H01L 2221/68327; H01L 2221/68377;
H01L 2224/05639; H01L 2224/05644;
H01L 2224/05647; H01L 2224/05655;
H01L 2224/05657; H01L 2224/05666;
H01L 2224/27003;                      (Cont.)

(86) International application number:
**PCT/JP2020/019910**

(87) International publication number:
**WO 2020/241407 (03.12.2020 Gazette 2020/49)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **24.05.2019 JP 2019097544**

(71) Applicant: LINTEC CORPORATION
Itabashi-ku
Tokyo 173-0001 (JP)

(72) Inventors:
• SATO, Yosuke
Tokyo 173-0001 (JP)
• ICHIKAWA, Isao
Tokyo 173-0001 (JP)
• NAKAYAMA, Hidekazu
Tokyo 173-0001 (JP)

(74) Representative: V.O.
P.O. Box 87930
2508 DH Den Haag (NL)

(54) **FILM-LIKE FIRING MATERIAL WITH SUPPORT SHEET, ROLL BODY, MULTILAYER BODY AND METHOD FOR PRODUCING DEVICE**

(57) Provided is a support sheet-attached film-shaped firing material 100 provided with a support sheet 2 having a pressure sensitive adhesive layer 4 on a base material film 3, and a film-shaped firing material 1 provided on the pressure sensitive adhesive layer 4. The support sheet-attached film-shaped firing material is used to affix the film-shaped firing material to an inner circumferential section on a surface side of a wafer having an annular convex portion on an outer circumferential section, the surface side thereof having the annular convex portion. The diameter of the film-shaped firing material 1 is less than or equal to the diameter of the inner circumferential section of the wafer.

Fig. 4

EP 3 979 300 A1

(52) Cooperative Patent Classification (CPC): (Cont.)
H01L 2224/27438; H01L 2224/2744;
H01L 2224/2919; H01L 2224/29191;
H01L 2224/2929; H01L 2224/29324;
H01L 2224/29338; H01L 2224/29339;
H01L 2224/29344; H01L 2224/29347;
H01L 2224/29355; H01L 2224/2936;
H01L 2224/29364; H01L 2224/29366;
H01L 2224/29369; H01L 2224/29386;
H01L 2224/29399; H01L 2224/32245;
H01L 2224/83191; H01L 2224/83203;
H01L 2224/8384

C-Sets
H01L 2224/05639;
H01L 2224/05644;
H01L 2224/05647;
H01L 2224/05655;
H01L 2224/05657;
H01L 2224/05666;
H01L 2224/2919;
H01L 2224/29191;
H01L 2224/2929;
H01L 2224/29324;
H01L 2224/29338;
H01L 2224/29339;
H01L 2224/29344;
H01L 2224/29347;
H01L 2224/29355;
H01L 2224/2936;
H01L 2224/29364;
H01L 2224/29366;
H01L 2224/29369;
H01L 2224/29386;
H01L 2224/29399

**Description**

Technical Field

The present invention relates to a support sheet-attached film-shaped firing material, a roll body, a laminate, and a method for manufacturing a device. The present application claims priority to JP 2019-097544 filed in Japan on May 24, 2019, the contents of which are incorporated herein.

Background Art

In recent years, the demand for power semiconductor elements (power devices) installed in automobiles, air conditioners, personal computers, and the like is increasing in association with an increase in the voltage and current levels thereof. Because power semiconductor elements are used under high voltage and high current conditions, the generation of heat from the semiconductor element tends to be problematic.

Typically, a heat sink is mounted around the semiconductor element to dissipate the heat generated from the semiconductor element. However, efficient heat dissipation is hindered if thermal conductivity at the junction between the heat sink and the semiconductor element is not good.

Patent Document 1 for example discloses, as a bonding material having excellent thermal conductivity, a paste-like metal particulate composition in which specific heat-sinterable metal particles, a specific polymeric dispersing agent, and a specific volatile dispersion medium are mixed. When sintered, the composition forms a solid metal with excellent thermal conductivity.

However, in a case in which a firing material is paste-like as in Patent Document 1, it is difficult to achieve a uniform thickness of the paste when applied, and the thickness stability tends to be poor.

Firing materials are typically provided as paste-like compositions, but the present inventors conceived of the idea of solving the problem of thickness stability by providing the firing material in the shape of a film. In order to achieve a film-shaped firing material, a binder component may be blended into the firing material, and then the firing material may be formed into a film shape.

Such a film-shaped firing material can be used, for example, for sinter bonding of chips, which are individual pieces by dicing a semiconductor wafer, to a substrate. In addition, if a support sheet is provided on one side (surface) of the film-shaped firing material, the film-shaped firing material can be used as a dicing sheet that is used when a semiconductor wafer is formed into individual chips. Furthermore, the film-shaped firing material can be processed into the same shape as a chip by using a blade or the like to form the film-shaped firing material into individual pieces together with the semiconductor wafer.

Meanwhile, with the advancement of thinner designs of semiconductor chips in recent years, a demand has arisen to reduce the typical thickness of wafers of about 350 $\mu$m to a thickness from 50 to 100 $\mu$m or even less. However, as the semiconductor wafer becomes thinner, the risk of damage during processing and transportation increases.

Therefore, grinding only the back surface inner circumferential section of a wafer when grinding the back surface, and leaving an annular convex portion on the back surface outer circumferential section to provide the wafer with rigidity has been proposed (Patent Documents 2 to 4). The rigidity of the annular convex portion is relatively high, and therefore the wafer that has been ground in the above-described form can be stably conveyed and stored, and damage during processing is reduced.

Citation List

Patent Literature

Patent Document 1: JP 2014-111800 A
Patent Document 2: JP 2007-19379 A
Patent Document 3: JP 2007-266352 A
Patent Document 4: JP 2007-287796 A

Summary of Invention

Technical Problem

However, when a support sheet-attached film-shaped firing material is applied to a semiconductor wafer like those described in Patent Documents 2 to 4, in some cases it is not possible to appropriately affix the support sheet-attached film-shaped firing material to the back surface of the wafer.

The present invention is developed to solve problems as described above, and an object of the present invention is to provide a support sheet-attached film-shaped firing material that can be used to appropriately affix a film-shaped firing material to an inner circumferential section on a surface side having an annular convex portion, of a wafer having the annular convex portion on an outer circumferential section.

Solution to Problem

Namely, the present invention includes the following aspects.
<1> A support sheet-attached film-shaped firing material including a support sheet having a pressure sensitive adhesive layer on a base material film, and a film-shaped firing material provided on the pressure sensitive adhesive layer, wherein

the support sheet-attached film-shaped firing material is used to affix the film-shaped firing material to an inner circumferential section on a surface side of a wafer having an annular convex portion on an outer circumferential section, the surface side thereof having the annular convex portion, and
a diameter of the film-shaped firing material is less than or equal to a diameter of the inner circumferential section of the wafer.

<2> A support sheet-attached film-shaped firing material including a support sheet having a pressure sensitive adhesive layer on a base material film, and a film-shaped firing material provided on the pressure sensitive adhesive layer, wherein
a diameter of the film-shaped firing material is from 130 to 146 mm, from 180 to 196 mm, from 280 to 296 mm, or from 430 to 446 mm.

<3> The support sheet-attached film-shaped firing material according to <1> or <2>, wherein

a thickness of the support sheet is 120 $\mu$m or less, and
a load of the support sheet when elongated by 5% is 13 N/15 mm or less as measured by the following measurement method:
measurement method: a test piece is obtained by cutting the support sheet to a width of 15 mm and a length of 150 mm (provided that for a case in which the pressure sensitive adhesive layer is curable, the test piece is obtained prior to curing), the test piece is drawn in a 23°C, 50% RH environment under conditions including a distance between chucks of 100 mm and a tensile speed of 200 mm/min, and the load with respect to a displacement amount is measured.

<4> The support sheet-attached film-shaped firing material according to any one of <1> to <3>, wherein the support sheet has an absorbance at a wavelength of 355 nm of 0.22 or less.
<5> The support sheet-attached film-shaped firing material according to any one of <1> to <4>, wherein the pressure sensitive adhesive layer is energy ray-curable.
<6> The support sheet-attached film-shaped firing material according to <5>, wherein the pressure sensitive adhesive layer includes a pressure sensitive adhesive resin, and the pressure sensitive adhesive resin has an energy ray-polymerizable unsaturated group in a side chain thereof.
<7> The support sheet-attached film-shaped firing material according to any one <1> to <6>, wherein the pressure sensitive adhesive layer includes a pressure sensitive adhesive resin, and the pressure sensitive adhesive resin includes a constituent unit derived from a (meth)acrylate having in a side chain an alkoxy group having from 8 to 18 carbons.
<8> The support sheet-attached film-shaped firing material according to any one of <1> to <7>, wherein a thickness of the film-shaped firing material before firing is from 10 to 200 $\mu$m.
<9> A roll body in which the support sheet-attached film-shaped firing material described in any one of <1> to <8> is laminated on a long release film with the film-shaped firing material being oriented inward, and the release film and the support sheet-attached film-shaped firing material are wound into a roll.
<10> A laminate obtained by affixing the support sheet-attached film-shaped firing material described in any one of <1> to <8> to an inner circumferential section on a surface side of a wafer having an annular convex portion in an outer circumferential section, the surface side thereof having the annular convex portion, and laminating the support sheet, the film-shaped firing material, and the wafer in this order.

<11> A method for manufacturing a device by sequentially implementing the following steps (1) to (5):

step (1): cutting away the annular convex portion of the laminate described in <10>;

step (2): dicing the wafer and the film-shaped firing material of the laminate from which the annular convex portion has been removed;

step (3): peeling apart the diced film-shaped firing material and the support sheet to obtain a film-shaped firing material-attached chip;

step (4): affixing the film-shaped firing material of the film-shaped firing material-attached chip to a front surface of a substrate; and

step (5): firing the film-shaped firing material of the film-shaped firing material-attached chip, and bonding the chip and the substrate.

Advantageous Effects of Invention

According to the present invention, a support sheet-attached film-shaped firing material can be provided which can be used to appropriately affix a film-shaped firing material to an inner circumferential section on a surface side of a wafer having an annular convex portion on an outer circumferential section, the surface side thereof having the annular convex portion.

Brief Description of Drawings

Fig. 1 is a cross-sectional view schematically illustrating a support sheet-attached film-shaped firing material according to an embodiment of the present invention.
Fig. 2 is a plan view of a circuit-forming surface of a semiconductor wafer.
Fig. 3 is a perspective view of a semiconductor wafer having an annular convex portion formed on a back surface outer circumferential section.
Fig. 4 is a cross-sectional view schematically illustrating a state in which the support sheet-attached film-shaped firing material according to an embodiment of the present invention is affixed to a semiconductor wafer and a ring frame.

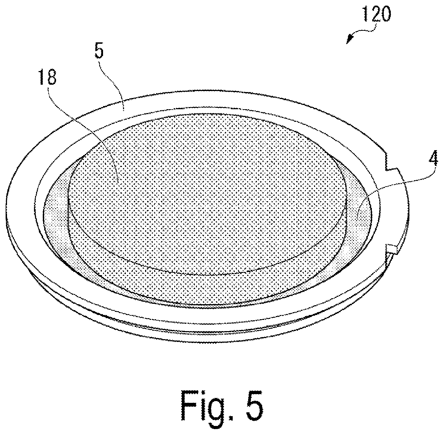

Fig. 5 is a perspective view schematically illustrating a state in which the support sheet-attached film-shaped firing material according to an embodiment of the present invention is affixed to a semiconductor wafer and a ring frame.
Fig. 6 is a cross-sectional view schematically illustrating a roll body according to an embodiment of the present invention.
Fig. 7A is a cross-sectional view schematically illustrating a method for manufacturing a device according to an embodiment of the present invention.
Fig. 7B is a cross-sectional view schematically illustrating a method for manufacturing a device according to an embodiment of the present invention.
Fig. 7C is a cross-sectional view schematically illustrating a method for manufacturing a device according to an embodiment of the present invention.
Fig. 7D is a cross-sectional view schematically illustrating a method for manufacturing a device according to an embodiment of the present invention.
Fig. 7E is a cross-sectional view schematically illustrating a method for manufacturing a device according to an embodiment of the present invention.

[Description of Embodiments]

One embodiment of the present invention will be described below with reference, as appropriate, to the drawings.
In order to facilitate understanding of the features of the present invention, the drawings used in the following description may, for convenience, illustrate an enlarged portion of a main part. Further, the dimensional ratios and the like of each constituent component may not necessarily be the same values as the actual dimensional ratios and the like.

<Support sheet-attached film-shaped firing material>

The support sheet-attached film-shaped firing material according to the present embodiment includes a support sheet having a pressure sensitive adhesive layer on a base material film, and a film-shaped firing material provided on the pressure sensitive adhesive layer, wherein the support sheet-attached film-shaped firing material is used to affix the film-shaped firing material to an inner circumferential section on a surface side of a wafer having an annular convex portion on an outer circumferential section, the surface side thereof having the annular convex portion, and a diameter of the film-shaped firing material is less than or equal to a diameter of the inner circumferential section of the wafer.

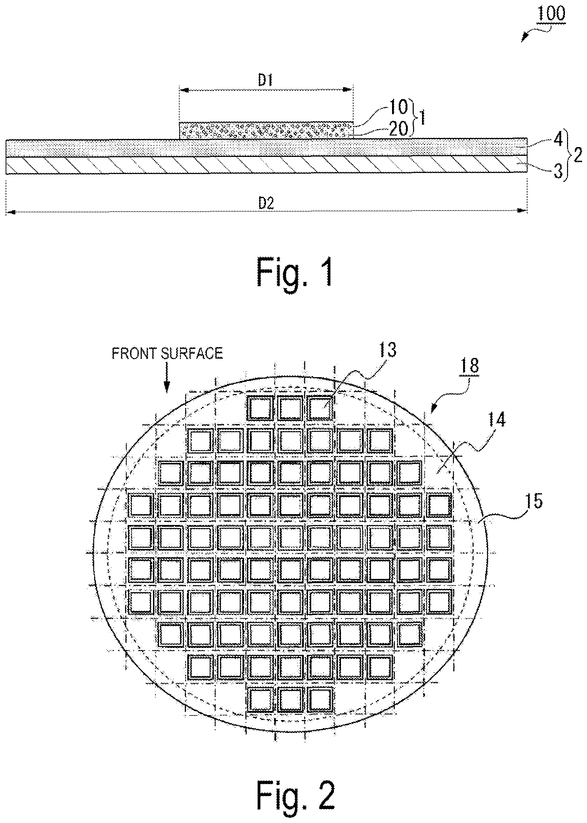

FIG. 1 is a cross-sectional view schematically illustrating a support sheet-attached film-shaped firing material according to the present embodiment. A support sheet-attached film-shaped firing material 100 is provided with a film-shaped firing material 1 containing sinterable metal particles 10 and a binder component 20, and a support sheet 2 provided on at least one side of the film-shaped firing material 1.

The support sheet-attached film-shaped firing material 100 of the present embodiment is formed by temporarily attaching the film-shaped firing material 1 to an inner circumferential section of the support sheet 2 including a base material film 3 and a pressure sensitive adhesive layer 4. The film-shaped firing material 1 is provided in direct contact with the pressure sensitive adhesive layer 4, and is configured such that a surface of the inner circumferential section of the pressure sensitive adhesive layer 4 is covered by the film-shaped firing material 1, and a pressure sensitive adhesion portion is exposed at an outer circumferential section.

In this configurational example, the film-shaped firing material 1 having a smaller diameter than that of the support sheet 2 is preferably detachably and concentrically laminated on the pressure sensitive adhesive layer 4 of the support sheet 2.

The support sheet-attached film-shaped firing material according to the present embodiment can be used as a dicing sheet that is used to form a semiconductor wafer into individual chips. Furthermore, the film-shaped firing material can be processed into the same shape as a chip by using a blade or the like to form the film-shaped firing material into individual pieces together with the semiconductor wafer, and thereby a film-shaped firing material-attached chip can be manufactured.

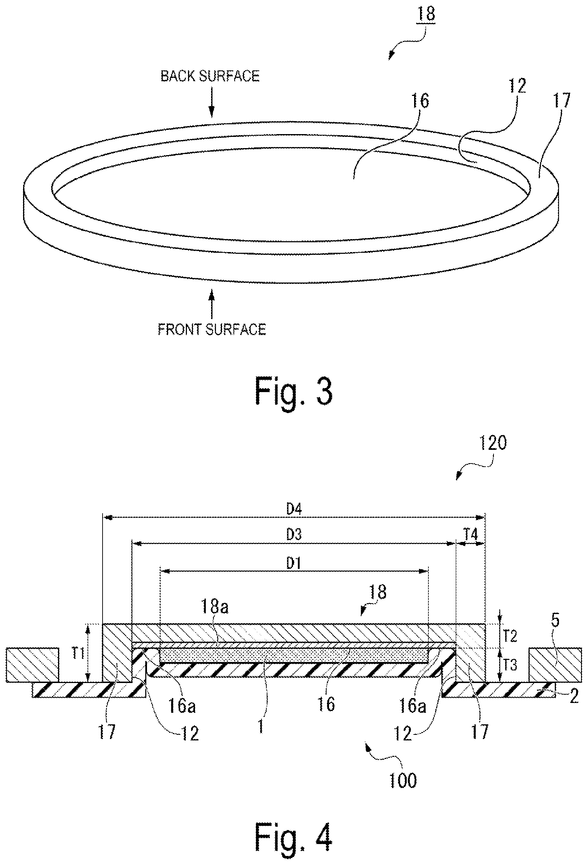

Figs. 2 to 3 are diagrams schematically illustrating an example of a wafer 18 having an annular convex portion on an outer circumferential section, the wafer 18 being an affixing target for the support sheet-attached film-shaped firing material 1. Hereinafter, the term "front surface" refers to a circuit-forming surface of the wafer, and the term "back surface" refers to a surface having an annular convex portion. As illustrated in Fig. 2, in the front surface of the wafer 18, a surplus portion 15 in which a circuit 13 is not formed is present in a range of several mm from the outer circumferential edge, and the circuit 13 is formed on a front surface inner circumferential section 14 excluding the surplus portion. In the wafer having the annular convex portion described above, a back surface inner circumferential section 16 corresponding to the circuit-forming portion (front surface inner circumferential section 14) of the front surface is ground to a predetermined thickness, and a back surface outer circumferential section corresponding to the surplus portion 15 where the circuit is not formed remains without being ground, resulting in an annular convex portion 17. The rigidity of the annular convex portion 17 is relatively high, and therefore the wafer 18 that has been ground in the above-described form can be stably conveyed and stored, and damage during processing is reduced. Note that Fig. 3 illustrates a perspective view from the back surface side at which the annular convex portion 17 is formed.

Examples of wafers or chips include semiconductor wafers or semiconductor chips, insulator wafers or insulator chips, and conductor wafers or conductor chips. Examples of the insulator wafer include glass wafers and sapphire wafers, but the insulator wafer is not limited thereto. In the present embodiment, a case in which a semiconductor wafer or a semiconductor chip is used as a wafer or a chip is described.

The film-shaped firing material 1 can be pasted to the back surface inner circumferential section 16 of the wafer 18 and used, but because the film-shaped firing material itself is brittle, handling of the pasting together tends to be poor. Therefore, as with the support sheet-attached film-shaped firing material of the present embodiment, the support sheet and the film-shaped firing material are pasted together in advance, and thereby the state of the affixed film-shaped firing material can be made uniform, and damage to the film-shaped firing material can be prevented. Furthermore, alignment is facilitated between the back surface inner circumferential section and the film-shaped firing material when affixing.

A relationship between the wafer 18 and the support sheet-attached film-shaped firing material 100 when the film-shaped firing material 1 of the support sheet-attached film-shaped firing material 100 of the present embodiment is affixed to the back surface inner circumferential section 16 of the wafer 18 having the annular convex portion 17 on the back surface outer circumferential section is described below.

Note that in the present specification, the "back surface inner circumferential section" of the wafer refers to a portion closer to a center side than the annular convex portion of the outer circumferential section, from a side of the wafer having the annular convex portion, and excludes the annular convex portion of the outer circumferential section.

Fig. 4 is a cross-sectional view illustrating a configuration in which the film-shaped firing material 1 is affixed to the back surface inner circumferential section 16. Fig. 4 is also a cross-sectional view schematically illustrating a laminate 120 according to a below-described embodiment of the present invention. In the support sheet-attached film-shaped firing material 100, a diameter D1 of the film-shaped firing material is less than or equal to a diameter D3 of the back surface inner circumferential section of the wafer, and from the perspective of ease of affixing, the diameter D1 is preferably smaller than the diameter D3, as illustrated in Fig. 4.

In a typical support sheet-attached film-shaped firing material, a diameter D4 of the wafer and the diameter D1 of the film-shaped firing material are the same, or the diameter D1 of the film-shaped firing material is larger than the diameter D4 of the wafer. However, when such a support sheet-attached film-shaped firing material is used, it is difficult to affix the film-shaped firing material to the back surface inner circumferential section 16 of the side of the wafer 18 having the annular convex portion 17, and problems such as damage to the film-shaped firing material occur. Furthermore, even in cases in which the film-shaped firing material is not damaged, if the diameter of the wafer and the diameter of the film-shaped firing material are the same, or when the diameter of the film-shaped firing material is larger than the diameter of the wafer, the film-shaped firing material 1 adheres to an inner side surface 12 of the annular convex portion or the like, and variations occur in the thickness of the film-shaped firing material 1 affixed to the back surface inner circumferential section 16.

Therefore, as illustrated in Fig. 4, in the support sheet-attached film-shaped firing material 100, the diameter D1 of the film-shaped firing material is less than or equal to the diameter D3 of the back surface inner circumferential section of the wafer, and thereby the film-shaped firing material 1 can be appropriately affixed to the back surface inner circumferential section 16.

The film-shaped firing material 1 is preferably formed in substantially the same shape as the shape of the back surface inner circumferential section 16 to be affixed. The shape of the back surface inner circumferential section 16 may be circular or substantially circular, and the shape of the film-shaped firing material 1 may also be circular or substantially circular. Note that the shapes of the wafer and the support sheet 2 may also be circular or substantially circular. A specific example of a substantially circular wafer is a wafer having a V-notch or a linear section (orientation flat) (however, even when the shape of the wafer 18 is substantially circular, the shape of the back surface inner circumferential section 16 may be circular).

Note that in the present specification, in a case in which the shape of each of the portions described above is not circular or substantially circular, the diameter when the shape is converted to a perfect circle based on the surface area can be used, and when the shape of each portion is circular or substantially circular but the shape is not a perfect circle, a diameter at which the length of the circle is a maximum can be adopted as the diameter.

The existing wafer size is unified by standards, and as the diameter (D4 in Fig. 4), diameters such as 150 mm, 200 mm, 300 mm, and 450 mm are used. The thickness (T4 in Fig. 4) of the annular convex portion 17 varies depending on the product. As the thickness of the annular convex portion 17 increases, the rigidity also increases, but the surface area of the circuit-forming portion is narrowed. As the thickness of the annular convex portion 17 is thinner, the surface area of the circuit-forming portion is wider, but the rigidity decreases. Taking these into consideration, the thickness (T4 in Fig. 4) of the annular convex portion 17 is normally from 2 to 5 mm, and the diameter (D3 in Fig. 4) of the back surface inner circumferential section 16 corresponding to the wafers of the standards described above is assumed to be from 140 to 146 mm, from 190 to 196 mm, from 290 to 296 mm, and from 440 to 446 mm, respectively.

The size of the film-shaped firing material 1 is preferably a size such that the back surface portion corresponding to the circuit-forming portion of the wafer can be effectively covered, and a value (D3 - D1) of the diameter (D3) of the back surface inner circumferential section 16 minus the diameter (D1) of the film-shaped firing material 1 may be, as an example, from 0 to 10 mm, or from 2 to 7 mm.

Here, a portion of the back surface inner circumferential section 16 that is closer to the outer circumference than an affixing portion of the film-shaped firing material 1, and which may correspond to the portion indicated by D3 - D1 above, is an outer circumferential section 16a of the back surface inner circumferential section (Fig. 4).

When the value of D3 - D1 is set to a range from 0 to 10 mm, as the support sheet-attached film-shaped firing material according to one embodiment, a support sheet-attached film-shaped firing material provided with a support sheet having a pressure sensitive adhesive layer on a base material film and a film-shaped firing material provided on the pressure sensitive adhesive layer, can be provided with the diameter D1 of the film-shaped firing material being from 130 to 146 mm, from 180 to 196 mm, from 280 to 296 mm, or from 430 to 446 mm.

The support sheet-attached film-shaped firing material can be suitably used to affix the film-shaped firing material to the back surface inner circumferential section of the wafer having an annular convex portion on the outer circumferential section.

Referring to Fig. 4, the pressure sensitive adhesive layer 4 (refer to Fig. 1) of the support sheet 2 is preferably affixed to the outer circumferential section 16a of the back surface inner circumferential section of the wafer 18. Through this, the film-shaped firing material 1 is covered by the pressure sensitive adhesive layer 4, the film-shaped firing material 1 and the wafer 18 are fixed by the pressure sensitive adhesive layer 4, and in a step of cutting away the annular convex portion in a below-described method of manufacturing a device, the support sheet 2 serves to reinforce the periphery of the outer circumferential section 16a of the back surface inner circumferential section of the portion to be cut, and thereby damage to the wafer is more effectively prevented.

To achieve such a configuration, it is preferable that the diameter D1 of the film-shaped firing material 1 be less than the diameter D3 of the back surface inner circumferential section 16 of the wafer. Furthermore, the diameter of the pressure sensitive adhesive layer 4 is preferably larger than the diameter D1 of the film-shaped firing material 1. For a case in which the size of the pressure sensitive adhesive layer 4 matches the size of the support sheet 2, the diameter D2 of the support sheet 2 is preferably larger than the diameter D1 of the film-shaped firing material 1.

Referring also to Fig. 4, the pressure sensitive adhesive layer 4 (refer to Fig. 1) of the support sheet 2 is preferably affixed to the inner side surface 12 of the annular convex portion of the wafer 18. Through this, the film-shaped firing material 1 is covered by the pressure sensitive adhesive layer 4, the film-shaped firing material 1 and the wafer 18 are fixed by the pressure sensitive adhesive layer 4, and in a step of cutting away the annular convex portion in the below-described method of manufacturing a device, the support sheet 2 serves to reinforce the periphery of the inner side surface 12 of the annular convex portion and of the outer circumferential section 16a of the back surface inner circumferential section of the portion to be cut, and thereby damage to the wafer is more effectively prevented.

To achieve such a configuration, the diameter of the pressure sensitive adhesive layer 4 is preferably larger than the diameter D1 of the film-shaped firing material 1, and is more preferably larger than the diameter D3 of the back surface inner circumferential section 16. In a case in which the size of the pressure sensitive adhesive layer 4 matches the size of the support sheet 2, the diameter D2 of the support sheet 2 is preferably larger than the diameter D1 of the film-shaped firing material 1, and is more preferably larger than the diameter D3 of the back surface inner circumferential section 16.

That is, when the film-shaped firing material 1 is affixed to the back surface inner circumferential section 16 of the wafer 18, the configuration is preferably such that the pressure sensitive adhesive layer 4 and at least a portion of the outer circumferential section 16a of the back surface inner circumferential section of the wafer 18 are in contact, and is more preferably such that the pressure sensitive adhesive layer 4 and at least a portion of the inner side surface 12 of the wafer 18 are in contact. The value (D2 - D1) obtained by subtracting the diameter (D1) of the film-shaped firing material 1 from the diameter (D2) of the support sheet 2 may be, for example, 35 mm or greater, or 50 mm or greater.

The diameter D2 of the support sheet 2 is preferably larger than the diameter D4 of the wafer 18. The support sheet-attached film-shaped firing material 100 affixed to the wafer 18 has a pressure sensitive adhesion portion where the pressure sensitive adhesive layer 4 is exposed at the outer circumferential section of the support sheet 2. As illustrated, the pressure sensitive adhesion portion of the outer circumferential section is used to fix a ring frame 5. The value (D2 - D4) obtained by subtracting the diameter (D4) of the wafer 18 from the diameter (D2) of the support sheet 2 may be, for example, 30 mm or greater, 50 mm or greater, or 60 mm or greater. The upper limit of the value of D2 - D4 may be set, as appropriate, in consideration of the size of the ring frame, and the value of D2 - D4 may be, for example, 550 mm or less, may be from 30 to 200 mm, may be from 50 to 150 mm, or may be from 60 to 100 mm.

An annular double-sided tape or a pressure sensitive adhesive layer may be provided separately on a glue margin (the pressure sensitive adhesive layer exposed at the outer circumferential section of the pressure sensitive adhesive sheet) with respect to the ring frame. The double-sided tape has a configuration of a pressure sensitive adhesive layer/core material/pressure sensitive adhesive layer, and the pressure sensitive adhesive layer of the double-sided tape is not particularly limited, and for example, a pressure sensitive adhesive of a rubber-based resin, an acrylic resin, a silicone resin, or a polyvinyl ether may be used. The pressure sensitive adhesive layer is affixed to the ring frame at the outer circumferential section thereof when manufacturing a below described substrate with a chip. Examples of the core material of the double-sided tape include a polyester film, a polypropylene film, a polycarbonate film, a polyimide film, a fluororesin film, and a liquid crystal polymer film.

The configuration pertaining to the size of each part described above is summarized as follows. Preferably, a relationship of (diameter D1 of the film-shaped firing material 1) $\leq$ (diameter D3 of the back surface inner circumferential section 16) < (diameter D4 of the wafer 18) < (diameter D2 of the support sheet 2) is satisfied, and more preferably, a relationship of (diameter D1 of the film-shaped firing material 1) < (diameter D3 of the back surface inner circumferential section 16) < (diameter D4 of the wafer 18) < (diameter D2 of the support sheet 2) is satisfied.

In the configuration illustrated in Fig. 4, a metal film 18a (also referred to as a back surface electrode) is provided on the back surface inner circumferential section 16 of the wafer 18. The support sheet-attached film-shaped firing material of the present embodiment is suitable for affixing to the wafer 18 provided with the metal film 18a on the back surface inner circumferential section 16. The metal film 18a may be provided to increase electrical conductivity or thermal conductivity. In order to protect the wafer, it is also conceivable to additionally affix, for example, a back-grinding tape to the circuit-forming surface side to increase the thickness of the wafer. However, when the metal film 18a is to be provided, sputtering vacuum pressure may be used, and when the back-grinding tape or the like is affixed in this case, there is concern that the performance of the metal film 18a may decrease due to the adherence of an organic substance derived from the back-grinding tape.

Thus, the wafer 18 provided with the metal film 18a is not sufficiently protected, and there may be a high risk of damage during processing or transportation. Therefore, the support sheet-attached film-shaped firing material according to the present embodiment is used and affixed to the wafer 18 provided with the metal film 18a, and thereby merits are provided including wafer protection and being able to exhibit a role as a dicing tape and form a sintered body having excellent performance of heat dissipation through the metal film 18a.

The metal film 18a can be formed from a metal such as gold, silver, copper, titanium, nickel, and cobalt.

Examples of methods for forming the metal film include vapor deposition by a physical vapor deposition (PVD) method such as vacuum deposition, sputtering, and ion plating, or electrolytic plating and electroless plating.

A total thickness T1 (refer to Fig. 4) of the annular convex portion 17 is not particularly limited as long as the total thickness imparts the rigidity necessary for the wafer and is a thickness that does not impair handling ease, and ordinarily, the total thickness T1 is from approximately 400 $\mu$m to approximately 780 $\mu$m or from approximately 400 $\mu$m to approximately 725 $\mu$m. In addition, a thickness T2 of the back surface inner circumferential section 16 is dependent on the design of the device, and typically is from approximately 25 $\mu$m to approximately 200 $\mu$m, and may be from 25 to 100 $\mu$m. Accordingly, a level difference T3 (= T1 - T2) between the back surface inner circumferential section 16 and the annular convex portion 17 is from approximately 200 $\mu$m to approximately 755 $\mu$m.

The thickness of the film-shaped firing material before firing is preferably less than the level difference T3. Through this, when the support sheet-attached film-shaped firing material is affixed to the wafer 18, the pressure sensitive adhesive layer 4 of the support sheet 2 can also be affixed to the inner side surface 12 of the annular convex portion, and in the step of cutting away the annular convex portion in the below-described method of manufacturing a device, the support sheet 2 serves to reinforce the periphery of the inner side surface 12 of the annular convex portion and of the outer circumferential section 16a of the back surface inner circumferential section of the portion to be cut, and thereby damage to the wafer is more effectively prevented.

Taking into account that the level difference T3 (= T1 - T2) is from approximately 200 $\mu$m to approximately 755 $\mu$m, the thickness of the film-shaped firing material before firing may be less than 200 $\mu$m, 200 $\mu$m or less, from 10 $\mu$m to less than 200 $\mu$m, from 10 $\mu$m to 200 $\mu$m, from 20 $\mu$m to 150 $\mu$m, or from 30 $\mu$m to 90 $\mu$m.

Furthermore, with respect to a manufactured product as well, by setting the thickness of the film-shaped firing material before firing to greater than or equal to the lower limit value described above, peeling apart is unlikely to occur between the chip and the substrate, and the reliability of the package can be further improved. Moreover, by setting the thickness of the film-shaped firing material before firing to less than or equal to the upper limit value described above, chip vibration can be suppressed and reliability of the package can be further improved.

Here, "thickness of the film-shaped firing material" refers to the overall thickness of the film-shaped firing material, and, for example, the thickness of a film-shaped firing material made from a plurality of layers refers to the total thickness of all layers configuring the film-shaped firing material.

Herein, the "thickness" can be obtained as a value expressed as an average of thickness measurements at any five locations using a constant pressure thickness meter in accordance with JIS K7130.

Until supplied for use, the support sheet-attached film-shaped firing material according to the present embodiment may be provided with a release film on the surface of either one or both of the film-shaped firing material and the pressure sensitive adhesion portion for the purpose of surface protection in order to avoid contact with the outside.

The surface protective film (release film) can be obtained by subjecting the surface of a base material film such as polyethylene, polyethylene terephthalate, polybutylene terephthalate, polyethylene naphthalate, and polypropylene described below to a release treatment using a release agent. Examples of the release agent used in the release treatment include the release agents exemplified in the description of the base material film.

The thickness of the support sheet-attached film-shaped firing material is preferably from 40 to 500 $\mu$m, more preferably from 50 to 300 $\mu$m, and even more preferably from 60 to 200 $\mu$m.

Here, "thickness of the support sheet-attached film-shaped firing material" refers to the thickness of the entire support sheet-attached film-shaped firing material, and means the total thickness of all layers configuring the support sheet-attached film-shaped firing material.

<Film-shaped firing material>

As illustrated in Fig. 1, the film-shaped firing material 1 contains sinterable metal particles 10 and a binder component 20.

The film-shaped firing material 1 may be formed from one layer (single layer) or may be formed from a plurality of layers of two or more. When the film-shaped firing material is made from a plurality of layers, the plurality of layers may be mutually the same or different, and combinations of these plurality of layers are not particularly limited as long as the effects of the present invention are not impaired.

Note that the present specification is not limited to the case of a film-shaped firing material, and the matter of "the plurality of layers may be mutually the same or different" means that "all layers may be the same, all layers may be different, or only some of the layers may be the same", and the matter of "the plurality of layers are mutually different" means that "the constituent materials of each layer and/or the blending ratios of the constituent materials and/or the thickness of the layers differs from that of the others".

(Release film)

The film-shaped firing material can be provided with a release film laminated thereon. When used, the release film may be peeled off, and the film-shaped firing material then placed on a target object to be sintered and bonded. The release film also functions as a protective film to prevent damage or dirt adhesion to the film-shaped firing material. The release film may be provided on at least one side of the film-shaped firing material.

The release film may be, for example, a transparent film such as a polyethylene film, a polypropylene film, a polybutene film, a polybutadiene film, a polymethylpentene film, a polyvinyl chloride film, a vinyl chloride copolymer film, a polyethylene terephthalate film, a polyethylene naphthalate film, a polybutylene terephthalate film, a polyurethane film, an ethylene vinyl acetate copolymer film, an ionomer resin film, an ethylene-(meth)acrylic acid copolymer film, an ethylene-(meth)acrylate copolymer film, a polystyrene film, a polycarbonate film, a polyimide film, and a fluororesin film. Crosslinked films of these may also be used. Laminated films of these may also be used. In addition, films obtained by coloring these, non-transparent films thereof, or the like can also be used. Examples of the release agent include silicone-based release agents, fluorine-based release agents, olefin-based release agents, alkyd-based release agents, and release agents of long-chain alkyl group-containing carbamates.

The approximate thickness of the release film is typically from 10 to 500 $\mu$m, preferably from 15 to 300 $\mu$m, and particularly preferably from 20 to 250 $\mu$m.

(Sinterable metal particles)

The sinterable metal particles are metal particles that can be heat-treated at a temperature equal to or greater than the melting point of the metal particles in the firing of the film-shaped firing material such that the particles can melt and bond together to form a sintered body. By forming the sintered body, the film-shaped firing material and an article fired in contact therewith can be sintered and bonded. Specifically, the chip and the substrate can be sintered and bonded together through the film-shaped firing material.

Examples of the constituent material of the sinterable metal particles include an elemental metal, barium titanate, an oxide of the elemental metal, and alloys thereof. Examples of the elemental metal include silver, gold, copper, iron, nickel, aluminum, silicon, palladium, platinum, and titanium. Silver and silver oxide are preferable as the constituent material of the sinterable metal particles. Only one type of sinterable metal particles may be blended, or a combination of two or more types may be blended.

The sinterable metal particles are preferably silver nanoparticles, which are nano-sized silver particles.

The particle diameter of the sinterable metal particles contained in the film-shaped firing material is not particularly limited as long as the particles are capable of exhibiting the aforementioned sinterability, but the particle diameter may be 100 nm or less, 50 nm or less, or 30 nm or less. Note that the particle diameter of the metal particles contained in the film-shaped firing material is the projected area circle equivalent diameter of the particle diameter of the metal particles observed with an electron microscope. Metal particles that fall within the above range of particle diameters are preferable because they have excellent sinterability.

With regard to the particle diameter of the sinterable metal particles contained in the film-shaped firing material, the number-average particle diameter of metal particles observed with an electron microscope, the number-average particle diameter being determined with respect to particles having a projected area circle equivalent diameter of 100 nm or less, may be from 0.1 to 95 nm, may be from 0.3 to 50 nm, or may be from 0.5 to 30 nm. Note that the quantity of metal particles to be measured is 100 or more per one film-shaped firing material, with the metal particles thereof being randomly selected.

The sinterable metal particles may be pre-dispersed in a high boiling point solvent having a high boiling point such as isobornyl cyclohexanol or decyl alcohol in order to create in advance a state in which aggregates are not present before mixing with the binder component and other additive components. The boiling point of the high boiling point solvent may be, for example, from 200 to 350°C. At this time, when a high boiling point solvent is used, almost no volatilization of the solvent occurs at ordinary temperature, and therefore an increase in the concentration of the sinterable metal particles is prevented, workability is improved, re-aggregation and the like of the sinterable metal particles are also prevented, and the quality also becomes favorable. Examples of dispersing methods include the use of a kneader, three rolls, a bead mill, and ultrasonic waves.

In addition to the metal particles (sinterable metal particles) having a particle diameter of not greater than 100 nm, non-sinterable metal particles having a particle diameter of greater than 100 nm and not corresponding to the sinterable metal particles may be further blended in the film-shaped firing material. With regard to the particle diameter of the non-sinterable metal particles having a particle diameter greater than 100 nm, the number-average particle diameter of metal particles observed with an electron microscope, the number-average particle diameter being determined with respect to particles having a projected area circle equivalent diameter of greater than 100 nm, may be greater than 150 nm and less than or equal to 50000 nm, may be from 150 to 10000 nm, or may be from 180 to 5000 nm.

Examples of the types of metals of the non-sinterable metal particles having a particle diameter greater than 100 nm include the same metals exemplified as the types of metals of the sinterable metal particles, and silver, copper, and oxides thereof are preferable.

The metal particles having a particle diameter of 100 nm or less and the non-sinterable metal particles having a particle diameter greater than 100 nm may be the same type of metal, or may be mutually different types of metals. For example, the metal particles having a particle diameter of 100 nm or less may be silver particles, while the non-sinterable metal particles having a particle diameter greater than 100 nm may be silver or silver oxide particles. Also for example, the metal particles having a particle diameter of 100 nm or less may be silver or silver oxide particles, while the non-sinterable metal particles having a particle diameter greater than 100 nm may be copper or copper oxide particles.

In the film-shaped firing material, the content of the sinterable metal particles relative to the total mass (100 mass%) of all of the metal particles may be from 10 to 100 mass%, or may be from 20 to 95 mass%.

The surface of the sinterable metal particles and/or the non-sinterable metal particles may be coated with an organic substance. Providing a coating of an organic substance improves miscibility with the binder component and can prevent the cohesion of particles, and thereby the particles can be uniformly dispersed.

When the sinterable metal particles and/or the non-sinterable metal particles are coated with an organic substance, the mass of the sinterable metal particles and the non-sinterable metal particles is a value including the coating.

(Binder component)

When a binder component is blended with the firing material, the firing material can be formed into a film shape, and pressure sensitive adhesiveness can be imparted to the film-shaped firing material before firing. The binder component may be a thermally decomposable binder component that is thermally decomposed when subjected to a heating treatment in the firing of the film-shaped firing material.

The binder component is not particularly limited, but examples of suitable binder components include resins. Examples of such resins include acrylic resins, polycarbonate resins, polylactic acid, and polymers of cellulose derivatives, and acrylic resins are preferable. Acrylic resins include homopolymers of (meth)acrylate compounds, copolymers of two or more types of (meth)acrylate compounds, and copolymers of a (meth)acrylate compound and another copolymerizable monomer.

In the present specification, "derivative" means a compound in which one or more hydrogen atoms of the original compound are substituted with a group (substituent) other than a hydrogen atom.

With respect to the resin constituting the binder component, the content of constituent units derived from a (meth)acrylate compound is, relative to the total mass (100 mass%) of the constituent units, preferably from 50 to 100 mass%, more preferably from 80 to 100 mass%, and even more preferably from 90 to 100 mass%.

In this context, "derived from" means that the monomer has undergone a change in the structure necessary for polymerization.

Specific examples of (meth)acrylate compounds include alkyl (meth)acrylates, such as methyl (meth)acrylate, ethyl (meth)acrylate, propyl (meth)acrylate, isopropyl (meth)acrylate, butyl (meth)acrylate, isobutyl (meth)acrylate, t-butyl (meth)acrylate, pentyl (meth)acrylate, amyl (meth)acrylate, isoamyl (meth)acrylate, hexyl (meth)acrylate, heptyl (meth)acrylate, octyl (meth)acrylate, isooctyl (meth)acrylate, 2-ethylhexyl (meth)acrylate, ethylhexyl (meth)acrylate, nonyl (meth)acrylate, decyl (meth)acrylate, isodecyl (meth)acrylate, undecyl (meth)acrylate, dodecyl (meth)acrylate, lauryl (meth)acrylate, stearyl (meth)acrylate, and isostearyl (meth)acrylate; hydroxyalkyl (meth)acrylates, such as hydroxyethyl (meth)acrylate, 2-hydroxypropyl (meth)acrylate, 4-hydroxybutyl (meth)acrylate, 3-hydroxypropyl (meth)acrylate, 2-hydroxybutyl (meth)acrylate, and 3-hydroxybutyl (meth)acrylate;

phenoxyalkyl (meth)acrylates, such as phenoxyethyl (meth)acrylate, and 2-hydroxy-3-phenoxypropyl (meth)acrylate;
alkoxyalkyl (meth)acrylates, such as 2-methoxyethyl (meth)acrylate, 2-ethoxyethyl (meth)acrylate, 2-propoxyethyl (meth)acrylate, 2-butoxyethyl (meth)acrylate, and 2-methoxybutyl (meth)acrylate;
polyalkylene glycol (meth)acrylates, such as polyethylene glycol mono (meth)acrylate, ethoxydiethylene glycol (meth)acrylate, methoxypolyethylene glycol (meth)acrylate, phenoxypolyethylene glycol (meth)acrylate, nonylphenoxy polyethylene glycol (meth)acrylate, polypropylene glycol mono(meth)acrylate, methoxypolypropylene glycol (meth)acrylate, ethoxypolypropylene glycol (meth)acrylate, and nonylphenoxy polypropylene glycol (meth)acrylate;
cycloalkyl (meth)acrylates, such as cyclohexyl (meth)acrylate, 4-butylcyclohexyl (meth)acrylate, dicyclopentanyl (meth)acrylate, dicyclopentenyl (meth)acrylate, dicyclopentadienyl (meth)acrylate, bornyl (meth)acrylate, isobornyl (meth)acrylate, and tricyclodecanyl (meth)acrylate; and
benzyl (meth)acrylate and tetrahydrofurfuryl (meth)acrylate. Alkyl (meth)acrylates or alkoxyalkyl (meth)acrylates are preferable, and particularly preferable (meth)acrylate compounds include butyl (meth)acrylate, ethylhexyl (meth)acrylate, lauryl (meth)acrylate, isodecyl (meth)acrylate, 2-ethylhexyl (meth)acrylate, and 2-ethoxyethyl (meth)acrylate.

Herein, "(meth)acrylate" is a concept that encompasses both "acrylate" and "methacrylate".

The acrylic resin is preferably a methacrylate. When the binder component contains a constituent unit derived from methacrylate, firing can be performed at a relatively low temperature, and conditions for obtaining sufficient adhesion strength after sintering can be easily satisfied.

With respect to the resin constituting the binder component, the content of constituent units derived from methacrylate is, relative to the total mass (100 mass%) of the constituent units, preferably from 50 to 100 mass%, more preferably from 80 to 100 mass%, and even more preferably from 90 to 100 mass%.

The other copolymerizable monomer is not particularly limited as long as it is a compound that can be copolymerized with the (meth)acrylate compound, and examples include unsaturated carboxylic acids such as (meth)acrylic acid, vinyl benzoate, maleic acid, and vinyl phthalate; and vinyl group-containing radical polymerizable compounds such as vinyl benzyl methyl ether, vinyl glycidyl ether, styrene, $\alpha$-methylstyrene, butadiene, and isoprene.

The mass average molecular weight (Mw) of the resin constituting the binder component is preferably from 1000 to 1000000, and more preferably from 10000 to 800000. When the mass average molecular weight of the resin is within the range described above, sufficient film strength is expressed as a film, and flexibility is easily imparted.

Note that in the present specification, unless otherwise specified, "mass average molecular weight" refers to a polystyrene equivalent value measured by gel permeation chromatography (GPC).

The glass transition temperature (Tg) of the resin constituting the binder component can be determined by calculation using the Fox equation presented below, and the glass transition temperature is preferably from -60°C to 50°C, more preferably from -30°C to 10°C, and even more preferably from -20°C to less than 0°C. When the Tg of the resin determined from the Fox equation is less than or equal to the upper limit described above, the pressure sensitive adhesive force before firing between the film-shaped firing material and an adherend (for example, a chip, a substrate, or the like) is improved. In addition, the flexibility of the film-shaped firing material is increased. Meanwhile, when the Tg of the resin determined from the Fox equation is greater than or equal to the lower limit described above, the film shape can be maintained, and the film-shaped firing material can be more easily peeled apart from the support sheet or the like.

$$1/Tg = (W1/Tg1) + (W2/Tg2) +...+ (Wm/Tgm)$$

(where Tg is the glass transition temperature of the resin constituting the binder component, Tg1, Tg2,... and Tgm are the glass transition temperatures of the homopolymers of each monomer serving as the raw materials of the resin constituting the binder component, and W1, W2,... and Wm are the mass fractions of each monomer. Of course, W1 + W2 +...+ Wm = 1.)

As the glass transition temperatures of the homopolymers of each monomer in the Fox equation, the glass transition temperature values described in the Polymer Data Handbook or in the Handbook of Pressure Sensitive Adhesive Technology can be used.

The binder component may be a thermally decomposable binder component that is thermally decomposed when subjected to a heating treatment in the firing of the film-shaped firing material. Thermal decomposition of the binder component can be confirmed by the mass loss of the binder component due to firing. Note that the component blended as a binder component may be nearly thermally decomposed by firing, but the total mass of the component blended as the binder component may also not be thermally decomposed by firing.

The binder component may be one for which the mass of the binder component after firing with respect to the total mass (100 mass%) of the binder component prior to firing is 10 mass% or less, 5 mass% or less, or 3 mass% or less.

In addition to the sinterable metal particles, the non-sinterable metal particles, and the binder component described above, the film-shaped firing material may contain other additives not corresponding to the sinterable metal particles, the non-sinterable metal particles, or the binder component, within a range that does not impair the effect of the present invention.

Examples of other additives that may be included in the film-shaped firing material include solvents, dispersants, plasticizers, tackifiers, storage stabilizers, antifoaming agents, thermal decomposition accelerators, and antioxidants. A single type of additive may be contained, or two or more types may be contained. These additives are not particularly limited, and those that are normally used in this field can be selected as appropriate.

The binder component is preferably thermally decomposed by a heating treatment in the firing of the film-shaped firing material, and therefore the content of a thermosetting resin such as epoxy resin with respect to 100 mass% of the binder component is preferably 10 mass% or less and more preferably 5 mass% or less, and even more preferably, the film-shaped firing material is substantially free of a thermosetting resin.

Furthermore, from the same perspective, in the resin constituting the binder component, the content of acrylate-derived constituent units from among "acrylates" and "methacrylates" relative to the total mass (100 mass%) of constituent units is preferably 10 mass% or less and more preferably 5 mass% or less, and even more preferably, the resin constituting the binder component is substantially free from an acrylate-derived constituent unit.

<Composition>

The film-shaped firing material may be formed from sinterable metal particles, a binder component, and other additives, and the sum of content amounts (mass%) of these may be 100 mass%. When the film-shaped firing material contains non-sinterable metal particles, the film-shaped firing material may be formed from sinterable metal particles, non-sinterable metal particles, a binder component, and other additives, and the sum of the content amounts (mass%) of these may be 100 mass%.

In the film-shaped firing material, the content of the sinterable metal particles relative to the total mass (100 mass%) of all components (hereinafter, referred to as "solid content") other than the solvent is preferably from 15 to 98 mass%, more preferably from 15 to 90 mass%, and even more preferably from 20 to 80 mass%. When the content of the sinterable metal particles is less than or equal to the upper limit described above, the content of the binder component can be sufficiently ensured, and therefore the film shape can be easily maintained. On the other hand, when the content of the sinterable metal particles is greater than or equal to the lower limit described above, the sinterable metal particles themselves or the sinterable metal particles and the non-sinterable metal particles are fused together during firing, and an effect of expressing a high bonding adhesion strength (shear adhesive force) after firing is also obtained.

When the film-shaped firing material contains non-sinterable metal particles, the total content of the sinterable metal particles and the non-sinterable metal particles relative to the total mass (100 mass%) of the solid content in the film-shaped firing material is preferably from 50 to 98 mass%, more preferably from 70 to 95 mass%, and even more preferably from 80 to 95 mass%.

The content of the binder component relative to the total mass (100 mass%) of the solid content in the film-shaped firing material is preferably from 2 to 50 mass%, more preferably from 5 to 30 mass%, and even more preferably from 5 to 20 mass%. When the content of the binder component is less than or equal to the upper limit described above, the content of the sinterable metal particles can be sufficiently ensured, and therefore the bonding adhesive force between the film-shaped firing material and the adherend is further improved. On the other hand, when the content of the binder component is greater than or equal to the lower limit described above, the film shape can be easily maintained.

In the film-shaped firing material, a mass ratio of the sinterable metal particles to the binder component ((sinterable metal particles):(binder component)) is preferably from 50:1 to 1:5, more preferably from 20:1 to 1:2, and even more preferably from 10:1 to 1:1. When the film-shaped firing material contains non-sinterable metal particles, the mass ratio of the sinterable metal particles and the non-sinterable metal particles to the binder component ((sinterable metal particles + non-sinterable metal particles):(binder component)) is preferably from 50:1 to 1:1, more preferably from 20:1 to 2:1, and even more preferably from 9:1 to 4:1.

The film-shaped firing material may contain a high boiling point solvent that is used when mixing the sinterable metal particles, the non-sinterable metal particles, the binder component, and other additive components. The content of the high boiling point solvent relative to the total mass (100 mass%) of the film-shaped firing material is preferably 20 mass% or less, more preferably 15 mass% or less, and even more preferably 10 mass% or less.

[Method of manufacturing the film-shaped firing material]

The film-shaped firing material can be formed using a firing material composition containing the constituent material. For example, a film-shaped firing material can be formed at a targeted location by applying or printing a firing material composition containing a solvent and each component for constituting the film-shaped firing material onto a surface on which the film-shaped firing material is to be formed, and then volatilizing the solvent as necessary.

An example of the surface on which the film-shaped firing material is to be formed is a surface of a release film.

When the firing material composition is applied by coating, the solvent is preferably one having a boiling point of lower than 200°C, and examples of such solvents include n-hexane (boiling point: 68°C), ethyl acetate (boiling point: 77°C), 2-butanone (boiling point: 80°C), n-heptane (boiling point: 98°C); methylcyclohexane (boiling point: 101°C), toluene (boiling point: 111°C), acetyl acetone (boiling point: 138°C), n-xylene (boiling point: 139°C), and dimethylformamide (boiling point: 153°C). These may be used alone or may be combined and used.

The firing material composition may be applied by a well-known method including, for example, methods using various coaters such as an air knife coater, a blade coater, a bar coater, a gravure coater, a comma coater (trade name), a roll coater, a roll knife coater, a curtain coater, a die coater, a knife coater, a screen coater, a Mayer bar coater, and a kiss coater.

In a case in which the firing material composition is printed, the solvent need only be one that can be volatilized and dried after printing, and the boiling point of the solvent is preferably from 65 to 350°C. Examples of such solvents include solvents having a boiling point of less than 200°C as exemplified above, isophorone (boiling point: 215°C), butyl carbitol (boiling point: 230°C), 1-decanol (boiling point: 233°C), butyl carbitol acetate (boiling point: 247°C), and isobornyl cyclohexanol (boiling point: 318°C).

When the boiling point exceeds 350°C, the solvent is less likely to volatilize in the volatilization and drying after printing, and as a result, it may be difficult to ensure a desired shape, or the solvent may remain in the film during firing, which may degrade the bonding adhesiveness. When the boiling point is lower than 65°C, the solvent is volatilized during printing, and the stability of the thickness may be impaired. When a solvent with a boiling point of from 200 to 350°C is used, an increase in viscosity caused by volatilization of the solvent during printing can be suppressed, and printing suitability can be obtained.

The firing material composition can be printed by a well-known printing method, and examples include methods such as letterpress printing such as flexographic printing, intaglio printing such as gravure printing, lithography printing such as offset printing, screen printing such as silk screen printing or rotary screen printing, and printing using various types of printers such as an inkjet printer.

The shape of the film-shaped firing material may be set, as appropriate, in accordance with the shape of the object to be sintered and bonded, and a circular, substantially circular, or rectangular shape is preferable. A circular or substantially circular shape is a shape corresponding to the shape of the semiconductor wafer. A rectangular shape is a shape corresponding to the shape of the chip. The corresponding shape may be the same shape or substantially the same shape as the shape of the object to be sintered and bonded.

In particular, when the firing material composition is printed, a film-shaped firing material having a desired shape is easily formed.

The drying conditions of the firing material composition are not particularly limited, but when the firing material composition contains a solvent, the composition is preferably heated and dried, and in this case, for example, drying is preferably implemented at a temperature from 70 to 250°C, or for example, from 80 to 180°C, for 10 seconds and to 10 minutes.

<Support sheet>

In the support sheet-attached film-shaped firing material according to the present embodiment, the load of the support sheet when elongated by 5% is preferably from 13 N/15 mm or less, more preferably 10 N/15 mm or less, and even more preferably 9 N/15 mm or less as measured by the following measurement method. The inventors discovered that with a support sheet-attached film-shaped firing material for which the load of the support sheet when elongated by 5% is less than or equal to the upper limit described above, wafer breakage is more effectively prevented in the step of cutting away the annular convex portion in the below-described method of manufacturing a device. It is thought that this is because when the load of the support sheet when elongated by 5% is less than or equal to the upper limit described above, the support sheet is more firmly affixed toward the boundary section between the inner side surface 12 of the annular convex portion and the back surface inner circumferential section 16, and thereby the effect of preventing damage to the wafer is excellent.

The lower limit of the load of the support sheet when elongated by 5% is, for example, preferably 2 N/15 mm or greater, more preferably 3 N/15 mm or greater, and even more preferably 4 N/15 mm or greater. When the load at 5% elongation is greater than or equal to the lower limit described above, an action of reinforcing the wafer is suitably exhibited in the step of cutting away the annular convex portion and in the dicing step of the below-described method for manufacturing a device, and wafer damage can be more effectively prevented.

An example of the numerical range of the above-described numerical values of the load of the support sheet when elongated by 5% may be from 2 N/15 mm to 13 N/15 mm, from 3 N/15 mm to 10 N/15 mm, or from 4 N/15 mm to 9 N/15 mm.

The load at 5% elongation is determined in accordance with JIS K7161 1994, and specifically, the load can be measured by the following method.

Measurement method: A test piece is obtained by cutting the support sheet to a width of 15 mm and a length of 150 mm (provided that for a case in which the pressure sensitive adhesive layer is curable, the test piece is obtained prior to curing), the test piece is drawn in a 23°C, 50% RH environment under conditions including a distance between chucks of 100 mm and a tensile speed of 200 mm/min, and the load with respect to a displacement amount when the test piece is elongated by 5% is measured.

The thickness of the support sheet is preferably 120 μm or less, more preferably from 35 to 120 μm, and even more preferably from 50 to 110 μm. It is thought when the load of the support sheet is less than or equal to the upper limit described above, the support sheet is more firmly affixed toward the boundary section between the inner side surface 12 of the annular convex portion and the back surface inner circumferential section 16, and thereby the effect of preventing damage to the wafer is excellent. In addition, when the thickness of the support sheet is greater than or equal to the lower limit described above, an action of reinforcing the wafer is suitably exhibited in the step of cutting away the annular convex portion and in the dicing step of the below-described method for manufacturing a device, and wafer damage can be more effectively prevented.

Here, the "thickness of the support sheet" refers to the thickness of the entire support sheet, and for example, the thickness of a support sheet formed from a plurality of layers refers to the total thickness of all of the layers configuring the support sheet.

In the support sheet-attached film-shaped firing material according to the present embodiment, the absorbance of the support sheet at the light beam wavelength of laser irradiation is preferably not greater than 0.22, more preferably from 0 to 0.2, and even more preferably from 0 to 0.18. When the support sheet has the configuration described above, breakage of the support sheet can be prevented for a case in which processing by a laser is implemented in the step of cutting away the annular convex portion and in the dicing step in the below-described method of manufacturing a device.

In the below-described method of manufacturing a device, there are many cases in which processing is implemented using a laser with a wavelength of 355 nm in the step of cutting away the annular convex portion and in the dicing step. The absorbance of the support sheet at a wavelength of 355 nm is preferably 0.22 or less, more preferably from 0 to 0.2, and even more preferably from 0 to 0.18.

(Base material film)

The base material film 3 of the support sheet 2 is not particularly limited, and examples thereof include low-density polyethylene (LDPE), linear low density polyethylene (LLDPE), an ethylene-propylene copolymer, polypropylene, polybutene, polybutadiene, polymethylpentene, an ethylene-vinyl acetate copolymer, an ethylene-(meth)acrylic acid copolymer, an ethylene-methyl (meth)acrylate copolymer, an ethylene-ethyl (meth)acrylate copolymer, polyvinyl chloride, a vinyl chloride-vinyl acetate copolymer, a polyurethane film, and a film made from an ionomer or the like. Note that "(meth)acrylic" is used herein in a sense that includes both acrylic and methacrylic.

Furthermore, for a case in which higher heat resistance is required for the support sheet, examples of the base material film 3 include polyester films such as polyethylene terephthalate, polybutylene terephthalate, and polyethylene naphthalate; and polyolefin films such as polypropylene, and polymethylpentene. Moreover, crosslinked films of these and films obtained by modifying these through radiation and discharging, etc. can also be used. The base material film may be a laminate of the above-mentioned films.

These films may be also used by laminating or combining two or more types. In addition, these films may be colored, printed, or the like, and used. Moreover, the film may be formed into a sheet by extrusion molding a thermoplastic resin, may be a stretched film, and may be formed into a sheet by forming a curable resin into a thin film through a predetermined means, and then curing the thin film.

The thickness of the base material film is not particularly limited and is preferably from 30 to 300 $\mu$m, and more preferably from 50 to 200 $\mu$m. When the thickness of the base material film is set to within the range described above, tearing of the base material film is unlikely to occur even when cutting is implemented through dicing. Furthermore, sufficient flexibility is imparted to the support sheet-attached film-shaped firing material, and therefore good affixing properties are exhibited with respect to a workpiece (for example, a semiconductor wafer or the like).

The base material film can also be obtained by coating a surface with a release agent and implementing a release treatment. Examples of the release agent used in the release treatment include alkyd-based release agents, silicone-based release agents, fluorine-based release agents, unsaturated polyester-based release agents, polyolefin-based release agents, and wax-based release agents. Alkyd-based release agents, silicone-based release agents, and fluorine-based release agents exhibit heat resistance and thus are preferable.

In order to subject the surface of the base material film to a release treatment using the release agent described above, a gravure coater, a Mayer bar coater, an air knife coater, a roll coater, or the like is used to coat the surface with the release agent as is without a solvent or diluted with a solvent or in the form of an emulsion, and the base material film coated with the release agent is then supplied at ordinary temperature or under heating, or is cured by an electron beam, or a laminate may be formed by wet lamination, dry lamination, hot-melt lamination, melt-extrusion lamination, coextrusion, or the like.

(Pressure sensitive adhesive layer)

The pressure sensitive adhesive layer 4 is in the form of a sheet or a film and can contain a pressure sensitive adhesive.

The support sheet 2 has a pressure sensitive adhesion portion on at least the outer circumferential section thereof. The pressure sensitive adhesion portion has a function of temporarily fixing the ring frame 5 at the outer circumferential section of the support sheet-attached film-shaped firing material 100, and the ring frame 5 is preferably releasable after the required steps. Therefore, a pressure-sensitive adhesive with weak pressure sensitive adhesiveness may be used for the pressure sensitive adhesive layer 4, or an energy ray-curable pressure sensitive adhesive having a reduced pressure sensitive adhesive force due to energy ray irradiation may be used. The pressure sensitive adhesive layer may be energy ray-curable or non-energy ray-curable. A re-releasable pressure sensitive adhesive layer can be formed from a variety of well-known pressure sensitive adhesives (for example, general purpose pressure sensitive adhesives such as rubber-based resins, acrylic resins, silicone resins, urethane resins, and polyvinyl ethers; pressure sensitive adhesives with surface irregularities, energy ray-curable pressure sensitive adhesives, and pressure sensitive adhesives containing a thermally expanding component).

Herein, "energy ray" means an electromagnetic wave or an energy ray having an energy quantum in a charged particle beam, and examples thereof include ultraviolet rays, radiation, and electron beams.

The ultraviolet rays can be irradiated by using, for example, a highpressure mercury lamp, a fusion lamp, a xenon lamp, a black light, LED lamp, or the like as a UV light source. The electron beams can be generated by an electron beam accelerator or the like and irradiated.

Herein, "energy ray-curable" refers to a property of curing by irradiation with an energy ray, and "non-energy ray-curable" means a property of not curing even when the composition is irradiated with an energy ray.

As illustrated in Fig. 1, the support sheet 2 may have a configuration in which the pressure sensitive adhesive layer 4 is provided on the entire upper surface of the base material film 3, the surface of the inner circumferential section of the pressure sensitive adhesive layer 4 is covered with a film-shaped firing material, and the pressure sensitive adhesion portion is exposed at the outer circumferential section. In this case, the outer circumferential section of the pressure sensitive adhesive layer 4 is used to fix the ring frame 5 described above, and the film-shaped firing material is laminated in a releasable manner on the inner circumferential section. As described above, a weak pressure sensitive adhesive may be used as the pressure sensitive adhesive layer 4, or an energy ray-curable pressure sensitive adhesive may be used.

An acrylic resin or a silicone resin is preferably used as the pressure-sensitive adhesive with weak pressure sensitive adhesiveness.

In a case in which an energy ray-curable re-releasable pressure sensitive adhesive layer is used in the support sheet having the configuration illustrated in Fig. 1, pressure sensitive adhesiveness may be reduced by irradiating in advance with energy rays a region at which the film-shaped firing material is laminated. At this time, the other regions are not irradiated with energy rays, and the pressure sensitive adhesive force may be maintained at a high level for the purpose of adhering to the ring frame 5, for example. To configure such that only the other regions are not irradiated with energy rays, an energy ray-shielding layer may be provided, for example, by printing in regions corresponding to the other regions of the base material film, and then irradiating the energy ray-shielding layer with energy rays from the base material film side. Furthermore, with the support sheet having the configuration illustrated in Fig. 1, in order to strengthen the adherence between the base material film 3 and the pressure sensitive adhesive layer 4, the surface of the base material film 3 on which the pressure sensitive adhesive layer 4 is provided may be subjected, as desired, to an unevenness-forming treatment through sandblasting, a solvent treatment, or the like, or may be subjected to a treatment such as a corona discharge treatment, electron beam irradiation, a plasma treatment, an ozone/ultraviolet irradiation treatment, a flame treatment, a chromic acid treatment, a hot air treatment, or other such oxidizing treatment. The surface thereof may also be subjected to a primer treatment.

The thickness of the pressure sensitive adhesive layer is not particularly limited, but is preferably from 1 to 100 $\mu$m, more preferably from 2 to 80 $\mu$m, and particularly preferably from 3 to 50 $\mu$m.

The pressure sensitive adhesive layer may consist of one layer (a single layer), or may be formed from a plurality of two or more layers. When the pressure sensitive adhesive layer is formed from a plurality of layers, these plurality of layers may be the same or different from each other, and combinations of these plurality of layers are not particularly limited as long as the effects of the present invention are not impaired.

<Pressure sensitive adhesive composition>

The pressure sensitive adhesive layer can be formed using a pressure sensitive adhesive composition containing a pressure sensitive adhesive. For example, the pressure sensitive adhesive layer can be formed on a targeted location by applying the pressure sensitive adhesive composition onto the surface on which the pressure sensitive adhesive layer is to be formed, and then drying as necessary. A more specific method of forming the pressure sensitive adhesive layer is described in greater detail below along with the method of forming the other layers. In the pressure sensitive adhesive composition, the ratio of the content of components that do not vaporize at ordinary temperature is ordinarily the same as the ratio of the content of the components of the pressure sensitive adhesive layer.

The pressure sensitive adhesive composition may be applied by a well-known method including, for example, methods using various coaters such as an air knife coater, a blade coater, a bar coater, a gravure coater, a roll coater, a roll knife coater, a curtain coater, a die coater, a knife coater, a screen coater, a Mayer bar coater, and a kiss coater.

The drying conditions of the pressure sensitive adhesive composition are not particularly limited, but when the pressure sensitive adhesive composition contains a below-described solvent, the pressure sensitive adhesive composition is preferably heated and dried. The pressure sensitive adhesive composition containing a solvent is preferably dried at a temperature of from 70 to 130°C for 10 seconds to 5 minutes.

When the pressure sensitive adhesive layer is energy ray-curable, examples of the pressure sensitive adhesive composition containing the energy ray-curable pressure sensitive adhesive, that is, examples of the energy ray-curable pressure sensitive adhesive composition include:

a pressure sensitive adhesive composition (1-1) containing a non-energy ray-curable pressure sensitive adhesive resin (I-1a) (hereinafter, may be abbreviated as a "pressure sensitive adhesive resin (I-1a)") and an energy ray-curable compound;

a pressure sensitive adhesive composition (1-2) containing an energy ray-curable pressure sensitive adhesive resin (I-2a) (hereinafter, may be abbreviated as a "pressure sensitive adhesive resin (I-2a)") having an unsaturated group introduced into a side chain of the non-energy ray-curable pressure sensitive adhesive resin (I-1a); and

a pressure sensitive adhesive composition (1-3) containing the pressure sensitive adhesive resin (I-2a) and an energy ray-curable compound.

When the pressure sensitive adhesive layer 4 is non-energy ray-curable, examples of the non-energy ray-curable pressure sensitive adhesive composition include a pressure sensitive adhesive composition (1-4) containing the pressure sensitive adhesive resin (1-1a).

Note that in the present specification, "pressure sensitive adhesive resin" is a concept that includes both a resin having pressure sensitive adhesiveness and a resin having adhesiveness, and includes, for example, not only a resin having pressure sensitive adhesiveness from the resin itself, but also a resin that exhibits pressure sensitive adhesiveness through combined use with another component such as an additive, and a resin that exhibits adhesiveness through the presence of a trigger such as heat or water.

Of the pressure sensitive adhesive compositions described above, the pressure sensitive adhesive composition (1-2) or the pressure sensitive adhesive composition (1-4) is preferable. By using the pressure sensitive adhesive composition (1-2) or the pressure sensitive adhesive composition (1-4), the pressure sensitive adhesive force at the interface between the pressure sensitive adhesive layer and the film-shaped firing material can be reduced, and the diced film-shaped firing material-attached chip can be more stably picked up.

The pressure sensitive adhesive composition (I-1) may be used, but as described above, it is more preferable to use the pressure sensitive adhesive composition (1-2). The reason for this is that with the pressure sensitive adhesive composition (1-2), energy ray curing properties can be exhibited even without using an energy ray-curable compound, and even a pressure sensitive adhesive resin having low miscibility with the energy ray-curable compound can be used without any problems.

For example, with the pressure sensitive adhesive composition (I-1), a highly polar pressure sensitive adhesive resin may be selected to increase the miscibility with the energy ray-curable compound. However, with a highly polar pressure sensitive adhesive resin, the pressure sensitive adhesive force tends to increase over time after affixing.

For example, with a pressure sensitive adhesive resin containing a constituent unit derived from a (meth)acrylate having in a side chain an alkoxy group having from 8 to 18 carbon atoms, an increase in pressure sensitive adhesive force over time after affixing does not easily occur, but miscibility with the energy ray-curable compound may be low. However, when the pressure sensitive adhesive resin is contained in the pressure sensitive adhesive composition (1-2) and has an energy ray-polymerizable unsaturated group on the side chain, both energy ray curing properties and reduced pressure sensitive adhesive force can be achieved at a high level without considering the problem of miscibility with the energy ray-curable compound.

When the pressure sensitive adhesive layer is energy ray-curable, the pressure sensitive adhesive layer formed using the pressure sensitive adhesive composition (1-2) includes a pressure sensitive adhesive resin, and the pressure sensitive adhesive resin has an energy ray-polymerizable unsaturated group on a side chain thereof.

Examples of the pressure sensitive adhesive layer include pressure sensitive adhesive layers containing a pressure sensitive adhesive resin, the pressure sensitive adhesive resin having an energy ray-polymerizable unsaturated group on a side chain thereof, and the pressure sensitive adhesive resin including a constituent unit derived from a (meth)acrylate having in a side chain an alkoxy group having from 8 to 18 carbons.

<Pressure sensitive adhesive composition (I-1)>

As described above, the pressure sensitive adhesive composition (I-1) contains a non-energy ray-curable pressure sensitive adhesive resin (I-1a) and an energy ray-curable compound.

[Pressure sensitive adhesive resin (I-1a)]

The pressure sensitive adhesive resin (I-1a) is preferably an acrylic resin.

Examples of the acrylic resin include acrylic polymers having at least a constituent unit derived from an alkyl (meth)acrylate.

The acrylic resin may have a single type of constituent unit or two or more types of constituent units, and when two or more types of constituent units are contained, the combinations and ratios thereof can be optionally selected.

With respect to the pressure sensitive adhesive resin constituting the pressure sensitive adhesive layer, the content of constituent units derived from a (meth)acrylate compound is, relative to the total mass (100 mass%) of the constituent units, preferably from 50 to 100 mass%, more preferably from 80 to 100 mass%, and even more preferably from 90 to 100 mass%.

In this context, "derived from" means that the monomer has undergone a change in the structure necessary for polymerization.

Specific examples of the (meth)acrylate compound include those exemplified with respect to the binder component described above.

The weight average molecular weight (Mw) of the acrylic resin is preferably from 10000 to 2000000, and more preferably from 100000 to 1500000. When the weight average molecular weight of the acrylic resin is within this range, the adhesive force between the pressure sensitive adhesive layer and the adherend can be easily adjusted to a preferable range.

On the other hand, when the weight average molecular weight of the acrylic resin is greater than or equal to the lower limit described above, shape stability (stability over time during storage) of the pressure sensitive adhesive layer is improved. Furthermore, by setting the weight average molecular weight of the acrylic resin to less than or equal to the upper limit described above, the pressure sensitive adhesive layer tends to easily track an uneven surface of an adherend, and the occurrence of voids and the like between the adherend and the pressure sensitive adhesive layer is further suppressed.

Note that in the present specification, unless otherwise specified, "weight average molecular weight" refers to a polystyrene equivalent value measured by gel permeation chromatography (GPC).

The glass transition temperature (Tg) of the acrylic resin is preferably from -60 to 70°C, and more preferably from -30 to 50°C. When the Tg of the acrylic resin is greater than or equal to the lower limit described above, the adhesive force between the pressure sensitive adhesive layer and the adherend is suppressed, and during pick-up, a film-shaped firing material-attached chip is easier to separate from the support sheet described below. When the Tg of the acrylic resin is less than or equal to the upper limit described above, the adhesive force between the pressure sensitive adhesive layer and the chip is improved.

The pressure sensitive adhesive resin preferably includes, among the (meth)acrylate compounds, a constituent unit derived from an alkyl (meth)acrylate, preferably includes a constituent unit derived from a (meth)acrylate having in a side chain an alkoxy group having from 8 to 18 carbons, and more preferably includes a constituent unit derived from an alkyl (meth)acrylate having in a side chain an alkoxy group having from 8 to 18 carbons. The number of carbons of the alkoxy group in the side chain is preferably from 8 to 18, more preferably from 8 to 12, and even more preferably from 8 to 10. The alkoxy group of the side chain may be linear or may be branched. The pressure sensitive adhesive resin includes a constituent unit derived from a (meth)acrylate having in a side chain an alkoxy group having from 8 to 18 carbons, and thereby the pressure sensitive adhesive force at the interface between the pressure sensitive adhesive layer and the film-shaped firing material is reduced, and the diced film-shaped firing material-attached chip can be more stably picked up.

In the pressure sensitive adhesive resin constituting the pressure sensitive adhesive layer, the content of constituent units derived from a (meth)acrylate having in a side chain an alkoxy group having from 8 to 18 carbons is preferably from 50 to 100 mass%, more preferably from 60 to 95 mass%, and even more preferably from 70 to 90 mass%, relative to the total mass (100 mass%) of the constituent units.

In addition to the constituent units derived from an alkyl (meth)acrylate, the acrylic polymer preferably further includes a constituent unit derived from a functional group-containing monomer.

Examples of the functional group-containing monomer include monomers in which the functional group reacts with a below-described crosslinking agent and thereby becomes a starting point for crosslinking, or the functional group reacts with an unsaturated group in an unsaturated group-containing compound described below and thereby an unsaturated group can be introduced into the side chain of the acrylic polymer.

Examples of the functional group in the functional group-containing monomer include a hydroxyl group, a carboxy group, an amino group, and an epoxy groups.

Examples of the functional group-containing monomer include a hydroxyl group-containing monomer, a carboxy group-containing monomer, an amino group-containing monomer, and an epoxy group-containing monomer.

Examples of the hydroxyl group-containing monomer include hydroxyalkyl (meth)acrylates, such as hydroxymethyl (meth)acrylate, 2-hydroxyethyl (meth)acrylate, 2-hydroxypropyl (meth)acrylate, 3-hydroxypropyl (meth) acrylate, 2-hydroxybutyl (meth)acrylate, 3-hydroxybutyl (meth)acrylate, and 4-hydroxybutyl (meth)acrylate; and non-(meth)acrylic unsaturated alcohols (i.e., an unsaturated alcohol not having a (meth)acryloyl skeleton), such as vinyl alcohol, and allyl alcohol.

Examples of the carboxy group-containing monomer include ethylenically unsaturated monocarboxylic acids (i.e., monocarboxylic acids having an ethylenically unsaturated bond), such as (meth)acrylic acid and crotonic acid;

ethylenically unsaturated dicarboxylic acids (i.e., dicarboxylic acids having an ethylenically unsaturated bond), such as fumaric acid, itaconic acid, maleic acid, and citraconic acid; anhydrides of the ethylenically unsaturated dicarboxylic acids; and carboxyalkyl (meth)acrylates such as 2-carboxyethyl methacrylate.

From the perspective of further reducing the pressure sensitive adhesive force of the pressure sensitive adhesive resin with regard to the film-shaped firing material containing sinterable metal particles, the content of the constituent units derived from (meth)acrylic acid relative to the total mass (100 mass%) of the constituent units of the pressure sensitive adhesive resin is preferably 10 mass% or less, more preferably 5 mass% or less, and even more preferably 2 mass% or less, and particularly preferably, the pressure sensitive adhesive resin substantially does not contain constituent units derived from (meth)acrylic acid.

The functional group-containing monomer is preferably a hydroxyl group-containing monomer or a carboxy group-containing monomer, and is more preferably a hydroxyl group-containing monomer.

The hydroxyl group-containing monomer is preferably a hydroxyalkyl (meth)acrylate. By using a hydroxy group-containing monomer, the pressure sensitive adhesive force at the interface between the pressure sensitive adhesive layer and the film-shaped firing material can be reduced, and the diced film-shaped firing material-attached chip can be more stably picked up.

The functional group-containing monomer constituting the acrylic polymer may be a single type, or may be two or more types, and when two or more types are contained, the combinations and ratios thereof can be optionally selected.

The content of the constituent units derived from the functional group-containing monomer in the acrylic polymer is preferably from 1 to 35 mass%, more preferably from 2 to 32 mass%, and particularly preferably from 3 to 30 mass%, relative to the total amount of constituent units.

The acrylic polymer can be used as the non-energy ray-curable pressure sensitive adhesive resin (I-1a) described above.

On the other hand, a resin obtained by reacting an unsaturated group-containing compound having an energy ray-polymerizable unsaturated group (energy ray-polymerizable group) with a functional group in the acrylic polymer can be used as the energy ray-curable pressure sensitive adhesive resin (I-2a) described above.

The pressure sensitive adhesive resin (I-1a) contained in the pressure sensitive adhesive composition (I-1) may be a single type, or may be two or more types, and when two or more types are used, the combinations and ratios thereof can be optionally selected.

In the pressure sensitive adhesive composition (I-1), the proportion of the content of the pressure sensitive adhesive resin (I-1a) with respect to the total mass of the pressure sensitive adhesive composition (I-1) is preferably from 5 to 99 mass%, more preferably from 10 to 95 mass%, and particularly preferably from 15 to 90 mass%.

[Energy ray-curable compound]

Examples of the energy ray-curable compound contained in the pressure sensitive adhesive composition (I-1) include monomers or oligomers that have an energy ray-polymerizable unsaturated group and are curable by irradiation with energy rays.

Among the energy ray-curable compounds, examples of monomers include polyvalent (meth)acrylates, such as trimethylolpropane tri(meth)acrylate, pentaerythritol (meth)acrylate, pentaerythritol tetra(meth)acrylate, dipentaerythritol hexa(meth)acrylate, 1,4-butylene glycol di(meth)acrylate, and 1,6-hexanediol (meth)acrylate; urethane (meth)acrylates; polyester (meth)acrylates; polyether (meth)acrylates; and epoxy (meth)acrylates.

Among the energy ray-curable compounds, examples of oligomers include oligomers obtained by polymerizing the monomers exemplified above.

The energy ray-curable compound is preferably a urethane (meth)acrylate or urethane (meth)acrylate oligomer in that the molecular weight is relatively large and the storage modulus of the pressure sensitive adhesive layer is less likely to be reduced.

The energy ray-curable compound contained in the pressure sensitive adhesive composition (I-1) may be a single type, or may be two or more types, and when two or more types are used, the combinations and ratios thereof can be optionally selected.

In the pressure sensitive adhesive composition (I-1), the proportion of the content of the energy ray-curable compound relative to the total mass of the pressure sensitive adhesive composition (I-1) is preferably from 1 to 95 mass%, more preferably from 5 to 90 mass%, and particularly preferably from 10 to 85 mass%.

[Crosslinking agent]

When the above-mentioned acrylic polymer having a constituent unit derived from a functional group-containing monomer besides a constituent unit derived from an alkyl (meth)acrylate is further used as the pressure sensitive adhesive resin (I-1a), the pressure sensitive adhesive composition (I-1) preferably further contains a crosslinking agent.

The crosslinking agent is, for example, a substance that reacts with the functional group and allows the pressure sensitive adhesive resin (I-1a) to be crosslinked.

Examples of crosslinking agents include isocyanate-based crosslinking agents (i.e., crosslinking agents having an isocyanate group), such as tolylene diisocyanate (TDI), hexamethylene diisocyanate (HDI), xylylene diisocyanate (XDI), and adducts of these diisocyanates; epoxy-based crosslinking agents (i.e., crosslinking agents having a glycidyl group), such as organic polyvalent isocyanate-based crosslinking agents and ethylene glycol glycidyl ether; aziridine-based crosslinking agents (i.e., crosslinking agents having an aziridinyl group), such as hexa[1-(2-methyl)-aziridinyl] triphosphatriazine; metal chelate-based crosslinking agents (i.e., crosslinking agents having a metal chelate structure), such as aluminum chelates; and isocyanurate-based crosslinking agents (i.e., crosslinking agents having an isocyanuric acid backbone).

The crosslinking agent is preferably an isocyanate-based crosslinking agent from perspectives such as the ease of procurement and improvements in the cohesive strength of the pressure sensitive adhesive and in the pressure sensitive adhesive force of the pressure sensitive adhesive layer.

More specific examples of the organic polyvalent isocyanate compound include 2,4-tolylene diisocyanate; 2,6-tolylene diisocyanate; 1,3-xylylene diisocyanate; 1,4-xylylene diisocyanate; diphenylmethane-4,4'-diisocyanate; diphenylmethane-2,4'-diisocyanate; 3-methyldiphenylmethane diisocyanate; hexamethylene diisocyanate; isophorone diisocyanate; dicyclohexylmethane-4,4'-diisocyanate; dicyclohexylmethane-2,4'-diisocyanate; compounds for which any one or more of tolylene diisocyanate, hexamethylene diisocyanate, and xylylene diisocyanate are added to all or some of the hydroxyl groups of a polyol such as trimethylolpropane; and lysine diisocyanate.

The crosslinking agent contained in the pressure sensitive adhesive composition (I-1) may be a single type, or may be two or more types, and when two or more types are used, the combinations and ratios thereof can be optionally selected.

When a crosslinking agent is used, the content of the crosslinking agent in the pressure sensitive adhesive composition (I-1) is preferably from 0.01 to 50 parts by mass, more preferably from 0.1 to 20 parts by mass, and particularly preferably from 0.3 to 15 parts by mass per 100 parts by mass of the content of the pressure sensitive adhesive resin (I-1a).

[Photopolymerization initiator]

The pressure sensitive adhesive composition (I-1) may further contain a photopolymerization initiator. When the pressure sensitive adhesive composition (I-1) contains a photopolymerization initiator, the curing reaction proceeds sufficiently even when the composition is irradiated with energy rays of relatively low energy such as ultraviolet light.

Examples of the photopolymerization initiator include benzoin compounds, such as benzoin, benzoin methyl ether, benzoin ethyl ether, benzoin isopropyl ether, benzoin isobutyl ether, benzoin benzoate, methyl benzoin benzoate, and benzoin dimethyl ketal; acetophenone compounds, such as acetophenone, 2-hydroxy-2-methyl-1-phenyl-propan-1-one, and 2,2-dimethoxy-1,2-diphenylethan-1-one; acylphosphine oxide compounds, such as bis(2,4,6-trimethylbenzoyl)phenyl phosphine oxide and 2,4,6-trimethylbenzoyldiphenyl phosphine oxide; sulfide compounds, such as benzylphenyl sulfide and tetramethylthiuram monosulfide; $\alpha$-ketol compounds such as 1-hydroxycyclohexyl phenyl ketone; azo compounds such as azobis-isobutyronitrile; titanocene compounds such as titanocene; thioxanthone compounds such as thioxanthone; peroxide compounds; diketone compounds such as diacetyl; benzyl; dibenzyl; benzophenone; 2,4-diethylthioxanthone; 1,2-diphenylmethane; 2-hydroxy-2-methyl-1-[4-(1-methylvinyl)phenyl]propanone; and 2-chloroanthraquinone.

In addition, for example, a quinone compound such as 1-chloroanthraquinone, or an optical sensitizer such as an amine can also be used as the photopolymerization initiator.

The photopolymerization initiator contained in the pressure sensitive adhesive composition (I-1) may be a single type, or may be two or more types, and when two or more types are used, the combinations and ratios thereof can be operationally selected.

When a photopolymerization initiator is used, the content of the photopolymerization initiator in the pressure sensitive adhesive composition (I-1) is preferably from 0.01 to 20 parts by mass, more preferably from 0.03 to 10 parts by mass, and particularly preferably from 0.05 to 5 parts by mass, per 100 parts by mass of the content of the energy ray-curable compound.

[Other additives]

The pressure sensitive adhesive composition (I-1) may contain, within a range that does not impair the effects of the present invention, other additives not corresponding to any of the components described above.

Examples of the other additives include well-known additives such as antistatic agents, antioxidants, softeners (plasticizers), filling materials (fillers), rust inhibitors, colorants (pigments, dyes), sensitizers, tackifiers, reaction retarders, and crosslinking accelerators (catalysts).

Note that the reaction retarder, for example, suppresses the progression of an undesired crosslinking reaction in the pressure sensitive adhesive composition (I-1) during storage by the action of a catalyst mixed into the pressure sensitive adhesive composition (I-1). Examples of reaction retarders include those that form a chelate complex through a chelate with respect to a catalyst, and more specifically, a reaction retarder having two or more carbonyl groups (-C(=O)-) per molecule.

The other additive contained in the pressure sensitive adhesive composition (I-1) may be a single type, or may be two or more types, and when two or more types are used, the combinations and ratios thereof can be optionally selected.

When other additives are used, the content of the other additives in the pressure sensitive adhesive composition (I-1) is not particularly limited, and may be appropriately selected according to the types thereof.

[Solvent]

The pressure sensitive adhesive composition (I-1) may contain a solvent. When the pressure sensitive adhesive composition (I-1) contains a solvent, suitability for coating onto a surface to be coated is improved.

The solvent is preferably an organic solvent, and examples of the organic solvent include ketones such as methyl ethyl ketone and acetone; esters (for example, carboxylates) such as ethyl acetate; ethers such as tetrahydrofuran and dioxane; aliphatic hydrocarbons such as cyclohexane and n-hexane; aromatic hydrocarbons such as toluene and xylene; and alcohols such as 1-propanol and 2-propanol.

As the solvent, for example, the solvent that was used when producing the pressure sensitive adhesive resin (I-1a) may be used as is in the pressure sensitive adhesive composition (I-1) without being removed from the pressure sensitive adhesive resin (I-1a), or a solvent of a same or different type as the solvent that was used when producing the pressure sensitive adhesive resin (I-1a) may be added separately when producing the pressure sensitive adhesive composition (I-1).

The solvent contained in the pressure sensitive adhesive composition (I-1) may be a single type, or may be two or more types, and when two or more types are used, the combinations and ratios thereof can be optionally selected.

When a solvent is used, the content of the solvent in the pressure sensitive adhesive composition (I-1) is not particularly limited and may be adjusted as appropriate.

<Pressure sensitive adhesive composition (I-2)>

As described above, the pressure sensitive adhesive composition (1-2) contains an energy ray-curable pressure sensitive adhesive resin (I-2a) in which an unsaturated group is introduced into a side chain of the non-energy ray-curable pressure sensitive adhesive resin (I-1a).

[Pressure sensitive adhesive resin (I-2a)]

The pressure sensitive adhesive resin (I-2a) is obtained, for example, by reacting an unsaturated group-containing compound having an energy ray-polymerizable unsaturated group with a functional group in the pressure sensitive adhesive resin (I-1a).

The unsaturated group-containing compound is a compound having, besides the energy ray-polymerizable unsaturated group, a group that can bond with the pressure sensitive adhesive resin (I-1a) by reacting with a functional group in the pressure sensitive adhesive resin (I-1a).

Examples of the energy ray-polymerizable unsaturated group include a (meth)acryloyl group, a vinyl group (also referred to as an ethenyl group), and an allyl group (also referred to as a 2-propenyl group), and a (meth)acryloyl group is preferable.

Examples of groups that can bond with a functional group in the pressure sensitive adhesive resin (I-1a) include isocyanate groups and glycidyl groups capable of bonding with hydroxyl groups or amino groups, and also hydroxyl groups and amino groups capable of bonding with carboxy groups or epoxy groups.

Examples of the unsaturated group-containing compound include (meth)acryloyloxyethyl isocyanate, (meth)acryloyl isocyanate, and glycidyl (meth)acrylate.

The pressure sensitive adhesive resin (I-2a) contained in the pressure sensitive adhesive composition (1-2) may be a single type, or may be two or more types, and when two or more types are used, the combinations and ratios thereof can be optionally selected.

In the pressure sensitive adhesive composition (1-2), the proportion of the content of the pressure sensitive adhesive resin (I-2a) with respect to the total mass of the pressure sensitive adhesive composition (1-2) is preferably from 5 to 99 mass%, more preferably from 10 to 95 mass%, and particularly preferably from 10 to 90 mass%.

In the pressure sensitive adhesive composition (1-2), the proportion of the content of the pressure sensitive adhesive resin (I-1a) to the total content of all components other than the solvent (that is, with respect to the pressure sensitive adhesive layer, the proportion of the content of the pressure sensitive adhesive resin (I-1a) with respect to the total mass of the pressure sensitive adhesive layer) is preferably from 50 to 100 mass%, and may be from 65 to 99 mass%, for example.

[Crosslinking agent]

When, for example, the same acrylic polymer as that of the pressure sensitive adhesive resin (I-1a), the acrylic monomer thereof having a constituent unit derived from a functional group-containing monomer, is used as the pressure sensitive adhesive resin (I-2a), the pressure sensitive adhesive composition (1-2) may further contain a crosslinking agent.

Examples of the crosslinking agent in the pressure sensitive adhesive composition (1-2) include the same crosslinking agents exemplified with respect to the pressure sensitive adhesive composition (I-1).

The crosslinking agent contained in the pressure sensitive adhesive composition (1-2) may be a single type, or may be two or more types, and when two or more types are used, the combinations and ratios thereof can be optionally selected.

When a crosslinking agent is used, the content of the crosslinking agent in the pressure sensitive adhesive composition (1-2) is preferably from 0.01 to 50 parts by mass, more preferably from 0.1 to 20 parts by mass, and particularly preferably from 0.3 to 3 parts by mass per 100 parts by mass of the content of the pressure sensitive adhesive resin (I-2a).

By setting the content of the crosslinking agent to be within the range described above in the pressure sensitive adhesive composition (1-2), the pressure sensitive adhesive force at the interface between the pressure sensitive adhesive layer and the film-shaped firing material can be reduced, and the diced film-shaped firing material-attached chip can be more stably picked up.

[Photopolymerization initiator]

The pressure sensitive adhesive composition (1-2) may further contain a photopolymerization initiator. When the pressure sensitive adhesive composition (1-2) contains a photopolymerization initiator, the curing reaction proceeds sufficiently even when the composition is irradiated with energy rays of relatively low energy such as ultraviolet light.

Examples of the photopolymerization initiator in the pressure sensitive adhesive composition (1-2) include the same photopolymerization initiators exemplified with respect to the pressure sensitive adhesive composition (I-1).

The photopolymerization initiator contained in the pressure sensitive adhesive composition (1-2) may be a single type, or may be two or more types, and when two or more types are used, the combinations and ratios thereof can be operationally selected.

When a photopolymerization initiator is used, the content of the photopolymerization initiator agent in the pressure sensitive adhesive composition (1-2) is preferably from 0.01 to 20 parts by mass, more preferably from 0.03 to 10 parts by mass, and particularly preferably from 0.05 to 5 parts by mass per 100 parts by mass of the content of the pressure sensitive adhesive resin (I-2a).

[Other additives]

The pressure sensitive adhesive composition (1-2) may contain, within a range that does not impair the effects of the present invention, other additives not corresponding to any of the components described above.

Examples of the other additives in the pressure sensitive adhesive composition (1-2) include the same additives as the other additives in the pressure sensitive adhesive composition (I-1).

The other additive contained in the pressure sensitive adhesive composition (1-2) may be a single type, or may be two or more types, and when two or more types are used, the combinations and ratios thereof can be optionally selected.

When other additives are used, the content of the other additives in the pressure sensitive adhesive composition (1-2) is not particularly limited, and may be appropriately selected according to the types thereof.

[Solvent]

The pressure sensitive adhesive composition (1-2) may contain a solvent for the same purpose as in the case of the pressure sensitive adhesive composition (I-1).

Examples of the solvent in the pressure sensitive adhesive composition (I-2) include the same solvents exemplified with respect to the pressure sensitive adhesive composition (I-1).

The solvent contained in the pressure sensitive adhesive composition (1-2) may be a single type, or may be two or more types, and when two or more types are used, the combinations and ratios thereof can be optionally selected.

When a solvent is used, the content of the solvent in the pressure sensitive adhesive composition (1-2) is not particularly limited and may be adjusted as appropriate.

<Pressure sensitive adhesive composition (I-3)>

As described above, the pressure sensitive adhesive composition (1-3) contains the pressure sensitive adhesive resin (I-2a) and an energy ray-curable compound.

In the pressure sensitive adhesive composition (1-3), the proportion of the content of the pressure sensitive adhesive resin (I-2a) with respect to the total mass of the pressure sensitive adhesive composition (1-3) is preferably from 5 to 99 mass%, more preferably from 10 to 95 mass%, and particularly preferably from 15 to 90 mass%.

[Energy ray-curable compound]

Examples of the energy ray-curable compound contained in the pressure sensitive adhesive composition (1-3) include monomers and oligomers that have an energy ray-polymerizable unsaturated group and are curable by irradiation with energy rays, and include the same energy ray-curable compounds contained in the pressure sensitive adhesive composition (I-1).

The energy ray-curable compound contained in the pressure sensitive adhesive composition (1-3) may be a single type, or may be two or more types, and when two or more types are used, the combinations and ratios thereof can be optionally selected.

In the pressure sensitive adhesive composition (1-3), the content of the energy ray-curable compound is preferably from 0.01 to 300 parts by mass, more preferably from 0.03 to 200 parts by mass, and particularly preferably from 0.05 to 100 parts by mass, per 100 parts by mass of the content of the pressure sensitive adhesive resin (I-2a).

[Photopolymerization initiator]

The pressure sensitive adhesive composition (1-3) may further contain a photopolymerization initiator. When the pressure sensitive adhesive composition (1-3) contains a photopolymerization initiator, the curing reaction proceeds sufficiently even when the composition is irradiated with energy rays of relatively low energy such as ultraviolet light.

Examples of the photopolymerization initiator in the pressure sensitive adhesive composition (1-3) include the same photopolymerization initiators exemplified with respect to the pressure sensitive adhesive composition (1-1).

The photopolymerization initiator contained in the pressure sensitive adhesive composition (1-3) may be a single type, or may be two or more types, and when two or more types are used, the combinations and ratios thereof can be operationally selected.

When a photopolymerization initiator is used, the content of the photopolymerization initiator in the pressure sensitive adhesive composition (1-3) is preferably from 0.01 to 20 parts by mass, more preferably from 0.03 to 10 parts by mass, and particularly preferably from 0.05 to 5 parts by mass, per 100 parts by mass of the total content of the pressure sensitive adhesive resin (I-2a) and the energy-ray-curable compound.

[Other additives]

The pressure sensitive adhesive composition (1-3) may contain, within a range that does not impair the effects of the present invention, other additives not corresponding to any of the components described above.

Examples of the other additives include the same additives as the other additives in the pressure sensitive adhesive composition (1-1).

The other additive contained in the pressure sensitive adhesive composition (1-3) may be a single type, or may be two or more types, and when two or more types are used, the combinations and ratios thereof can be optionally selected.

When other additives are used, the content of the other additives in the pressure sensitive adhesive composition (1-3) is not particularly limited, and may be appropriately selected according to the types thereof.

[Solvent]

The pressure sensitive adhesive composition (1-3) may contain a solvent for the same purpose as in the case of the pressure sensitive adhesive composition (I-1).

Examples of the solvent in the pressure sensitive adhesive composition (I-3) include the same solvents exemplified with respect to the pressure sensitive adhesive composition (1-1).

The solvent contained in the pressure sensitive adhesive composition (1-3) may be a single type, or may be two or more types, and when two or more types are used, the combinations and ratios thereof can be optionally selected.

When a solvent is used, the content of the solvent in the pressure sensitive adhesive composition (1-3) is not particularly limited and may be adjusted as appropriate.

<Pressure sensitive adhesive composition other than the pressure sensitive adhesive compositions (1-1) to (I-3)>

The pressure sensitive adhesive composition (1-1), the pressure sensitive adhesive composition (1-2), and the pressure sensitive adhesive composition (1-3) were primarily described above. However, the components described as components contained in these compositions can be similarly used in a general pressure sensitive adhesive composition other than these three types of pressure sensitive adhesive compositions (such general purpose sensitive adhesive composition is referred to herein as a "pressure sensitive adhesive composition other than the pressure sensitive adhesive compositions (1-1) to (1-3)").

Examples of pressure sensitive adhesive compositions other than the pressure sensitive adhesive compositions (1-1) to (1-3) include, besides energy ray-curable pressure sensitive adhesive compositions, non-energy ray-curable pressure sensitive adhesive compositions.

Examples of non-energy ray-curable pressure sensitive adhesive compositions include pressure sensitive adhesive compositions (1-4) containing a non-energy ray-curable pressure sensitive adhesive resin (I-1a), such as an acrylic resin, a urethane resin, a rubber-based resin, a silicone resin, an epoxy resin, a polyvinyl ether, a polycarbonate, and an ester-based resin, and a non-energy ray-curable pressure sensitive adhesive composition containing an acrylic resin is preferable.

The pressure sensitive adhesive composition other than the pressure sensitive adhesive compositions (1-1) to (1-3) preferably contains one or more types of crosslinking agents, and the content thereof may be the same as in the case of the pressure sensitive adhesive composition (1-1) and the like described above.

<Pressure sensitive adhesive composition (I-4)>

Preferable examples of the pressure sensitive adhesive composition (1-4) include those containing the pressure sensitive adhesive resin (I-1a) and a crosslinking agent.

[Pressure sensitive adhesive resin (I-1a)]

Examples of the pressure sensitive adhesive resin (I-1a) in the pressure sensitive adhesive composition (1-4) include the same pressure sensitive adhesive resins (I-1a) exemplified with respect to the pressure sensitive adhesive composition (1-1).

The pressure sensitive adhesive resin (I-1a) contained in the pressure sensitive adhesive composition (1-4) may be a single type, or may be two or more types, and when two or more types are used, the combinations and ratios thereof can be optionally selected.

In the pressure sensitive adhesive composition (1-4), the proportion of the content of the pressure sensitive adhesive resin (I-1a) with respect to the total mass of the pressure sensitive adhesive composition (1-4) is preferably from 5 to 99 mass%, more preferably from 10 to 95 mass%, and particularly preferably from 15 to 90 mass%.

In the pressure sensitive adhesive composition (1-4), the proportion of the content of the pressure sensitive adhesive resin (I-1a) to the total content of all components other than the solvent (that is, with respect to the pressure sensitive adhesive layer, the proportion of the content of the pressure sensitive adhesive resin (I-1a) with respect to the total mass of the pressure sensitive adhesive layer) is preferably from 50 to 100 mass%, and for example, may be from 65 to 99 mass%, or from 80 to 98 mass%.

[Crosslinking agent]

When the acrylic polymer having a constituent unit derived from a functional group-containing monomer besides a constituent unit derived from an alkyl (meth)acrylate is further used as the pressure sensitive adhesive resin (I-1a), the pressure sensitive adhesive composition (1-4) preferably further contains a crosslinking agent.

Examples of the crosslinking agent in the pressure sensitive adhesive composition (1-4) include the same crosslinking agents exemplified with respect to the pressure sensitive adhesive composition (1-1).

The crosslinking agent contained in the pressure sensitive adhesive composition (1-4) may be a single type, or may be two or more types, and when two or more types are used, the combinations and ratios thereof can be optionally selected.

The content of the crosslinking agent in the pressure sensitive adhesive composition (1-4) is preferably from 0.01 to 50 parts by mass, more preferably from 0.1 to 20 parts by mass, and particularly preferably from 4 to 15 parts by mass, per 100 parts by mass of the content of the pressure sensitive adhesive resin (I-1a).

By setting the content of the crosslinking agent in the pressure sensitive adhesive composition (1-4) to within the range described above, the pressure sensitive adhesive force at the interface between the pressure sensitive adhesive layer and the film-shaped firing material is reduced, and the diced film-shaped firing material-attached chip can be more stably picked up.

[Other additives]

The pressure sensitive adhesive composition (1-4) may contain, within a range that does not impair the effects of the present invention, other additives not corresponding to any of the components described above.
Examples of the other additives include the same additives as the other additives in the pressure sensitive adhesive composition (1-1).
The other additive contained in the pressure sensitive adhesive composition (1-4) may be a single type, or may be two or more types, and when two or more types are used, the combinations and ratios thereof can be optionally selected.
When other additives are used, the content of the other additives in the pressure sensitive adhesive composition (1-4) is not particularly limited, and may be appropriately selected according to the types thereof.

[Solvent]

The pressure sensitive adhesive composition (1-4) may contain a solvent for the same purpose as in the case of the pressure sensitive adhesive composition (I-1).
Examples of the solvent in the pressure sensitive adhesive composition (I-4) include the same solvents exemplified with respect to the pressure sensitive adhesive composition (1-1).
The solvent contained in the pressure sensitive adhesive composition (1-4) may be a single type, or may be two or more types, and when two or more types are used, the combinations and ratios thereof can be optionally selected.
When a solvent is used, the content of the solvent in the pressure sensitive adhesive composition (1-4) is not particularly limited and may be adjusted as appropriate.

[Method for producing the pressure sensitive adhesive composition]

The pressure sensitive adhesive compositions (1-1) to (1-3) and the pressure sensitive adhesive compositions other than the pressure sensitive adhesive compositions (1-1) to (1-3) such as the pressure sensitive adhesive composition (I-4) are obtained by blending the various components constituting the pressure sensitive adhesive compositions such as the pressure sensitive adhesive and, as necessary, components other than the pressure sensitive adhesive.
The order in which the components are added when blended is not particularly limited, and two or more types of components may be added simultaneously.
When a solvent is used, the solvent may be mixed with any of the to-be-blended components other than the solvent, and the blended components thereof may be pre-diluted and used, or the solvent may be mixed with these to-be-blended components and used without pre-diluting any of the to-be-blended components other than the solvent.
The method for mixing the components when blending is not particularly limited and may be selected as appropriate from well-known methods, such as a method of mixing by rotating a stirrer, a stirring blade, or the like, a method of mixing using a mixer, and a method of mixing with the application of ultrasonic waves.
The temperature and time when adding and mixing the various components are not particularly limited as long as each of the to-be-blended components is not degraded, and may be adjusted as appropriate, but the temperature is preferably from 15 to 30°C.

[Method of manufacturing the support sheet-attached film-shaped firing material]

The support sheet-attached film-shaped firing material according to the present embodiment can be manufactured by sequentially laminating each of the layers described above so as to have a corresponding positional relationship.
For example, when the pressure sensitive adhesive layer is to be laminated on the base material film, a pressure sensitive adhesive composition containing both a solvent and the components for forming the pressure sensitive adhesive layer is coated onto a release film and dried as necessary to volatilize the solvent, and a film shape is formed, and thereby the pressure sensitive adhesive layer is formed in advance on the release film, and then an exposed surface of the formed pressure sensitive adhesive layer, the exposed surface being on a side opposite the side contacting the release film, is pasted to the surface of a base material film. After formation of the laminated structure, the release film may be removed as necessary.
For example, for a case in which a support sheet-attached film-shaped firing material (a support-sheet-attached film-shaped firing material in which the support sheet is a laminate of a base material film and a pressure sensitive adhesive layer) is to be manufactured, the support sheet-attached film-shaped firing material being obtained by laminating a pressure sensitive adhesive layer onto a base material film and then laminating a film-shaped firing material onto the pressure sensitive adhesive layer, the pressure sensitive adhesive layer is laminated onto the base material film by the above-described method, and separately, a firing material composition containing a solvent and components for configuring the film-shaped firing material is coated or printed onto the release film and dried as necessary to volatilize the solvent, and thereby a film shape is formed, and as a result, the film-shaped firing material is formed on the release film, after which the exposed surface of this film-shaped firing material is pasted to an exposed surface of the pressure sensitive adhesive layer laminated on the base material film, and the film-shaped firing material is laminated on the pressure sensitive adhesive layer, and thereby a support sheet-attached film-shaped firing material is obtained. For a case in which a film-shaped firing material is to be formed on a release film, the firing material composition is preferably coated or printed onto a release-treated surface of the release film, and the release film may be removed as necessary after the laminated structure is formed.

In this manner, all of the layers other than the base material film constituting the support sheet-attached film-shaped firing material can be formed in advance on the release film and laminated by a method of pasting to the surface of the target layer, and therefore a layer in which this type of step is adopted may be appropriately selected as necessary to produce a support sheet-attached film-shaped firing material.

Note that after all of the necessary layers have been provided, the support sheet-attached film-shaped firing material may be stored in a state in which the release film is pasted to the surface of the outermost layer on the side opposite the support sheet.

«Roll body»

As an embodiment of the present invention, a roll body is provided in which a support sheet-attached film-shaped firing material is laminated onto a long release film with the film-shaped firing material being oriented inward, and the release film and the support sheet-attached film-shaped firing material are wound into a roll.

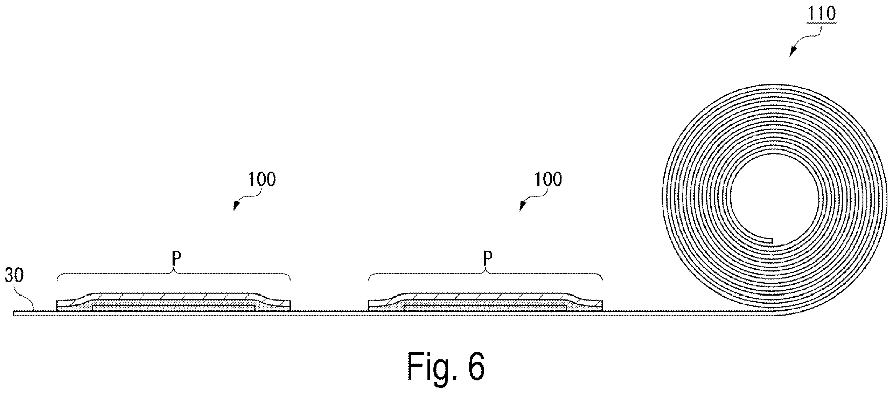

Fig. 6 is a cross-sectional view schematically illustrating a roll according to an embodiment of the present invention, and illustrates a state in which the roll is unwound, and a portion thereof is extended. Two or more units of a support sheet-attached film-shaped firing material 100 that has been processed into a predetermined shape are laminated onto a release film 30 of a roll body 110 with the film-shaped firing material oriented to the inside. With the release film 30 and the support sheet-attached film-shaped firing material 100, the support sheet-attached film-shaped firing material 100 is wound into a roll such that the laminated side is oriented toward the center side. The direction of roll winding is the longitudinal direction of the long release film 30.

One unit of the support sheet-attached film-shaped firing material may be a portion of a support sheet-attached film-shaped firing material used in affixing once or in affixing one to-be-affixed object, and can be used as a portion included in a unit P in Fig. 6. In Fig. 6, one film-shaped firing material 1 is included in each unit P, and two or more units P are continuously arranged at predetermined intervals. The support sheet-attached film-shaped firing materials included in the respective units P may be processed to have mutually the same shape. The preferred shape of the support sheet-attached film-shaped firing material is a shape in which a circular support sheet and a circular film-shaped firing material having a smaller diameter than that of the support sheet are concentrically laminated.

The film-shaped firing material 1 is adhesive and can be easily affixed to a semiconductor wafer or the like (to-be-affixed object), and therefore the film-shaped firing material 1 is suitable for storage in a roll shape by sandwiching the film-shaped firing material 1 between a release film 30 with poor adherence and the support sheet 2.

The roll body is also suitable as a distribution form for the support sheet-attached film-shaped firing material.

The roll body can be manufactured by laminating the support sheet-attached film-shaped firing material and the release film so as to have a corresponding positional relationship.

«Laminate»

As an embodiment of the present invention, a laminate obtained by affixing the support sheet-attached film-shaped firing material and a wafer and laminating the support sheet, the film-shaped firing material, and the wafer in this order is provided.

The laminate can be used as an intermediate in the below-described method for manufacturing a device.

Fig. 4 is also a cross-sectional view schematically illustrating a laminate according to an embodiment of the present invention. A laminate 120 is formed by laminating a support sheet-attached film-shaped firing material 100 and a semiconductor wafer 18, and then laminating a support sheet 2, a film-shaped firing material 1, and the semiconductor wafer 18 in this order. The semiconductor wafer 18 may be provided in direct contact with the film-shaped firing material 1. In the configuration shown here, the film-shaped firing material 1 is provided in direct contact with a metal film 18a (also referred to as a back surface electrode), which is one element of the semiconductor wafer 18.

The semiconductor wafer may be a silicon wafer and a silicon carbide wafer, or may be a compound semiconductor wafer such as gallium arsenide. A circuit may be formed on the surface of the semiconductor wafer. The circuit can be formed on the wafer surface by a variety of methods including conventional commonly-used methods such as etching and lift-off. The surface (back surface) opposite the circuit surface of the semiconductor wafer may be ground by a known means using a grinder or the like. When the back surface is to be ground, a pressure sensitive adhesive sheet called a front surface protective sheet can be affixed to the circuit surface to protect the circuit on the front surface. When the back surface is to be ground, the circuit surface side (i.e., the front surface protective sheet side) of the wafer is fixed using a chuck table or the like, and the back surface side on which the circuit is not formed can be ground using a grinder. Referring to Figs. 2 and 3, when the back surface is to be ground, first the entire back surface is ground to a predetermined thickness, after which only the back surface inner circumferential section 16 corresponding to the circuit-forming portion (front surface inner circumferential section 14) of the front surface is ground, and a back surface region corresponding to a surplus portion 15 where the circuit 13 is not formed remains without being ground. As a result, only the back surface inner circumferential section 16 of the semiconductor wafer 18 after grinding is further thinly ground, and an annular convex portion 17 remains on the outer circumferential portion. This type of back surface grinding can be implemented by a known technique described in, for example, the above-mentioned Patent Documents 2 to 4. Next, as necessary, a crushed layer generated during the back surface grinding is removed.

The crushed layer can be removed by chemical etching, plasma etching, or the like. After grinding, a metal film 18a may be provided on the back surface, and the metal film may be a single film or a plurality of films. The metal film can be formed using various methods such as electrolytic or electroless plating, and sputtering.

The shape of the workpiece (wafer or the like) to be affixed is typically circular or substantially circular, and thus the shapes of the film-shaped firing material 1 and the support sheet 2 are also preferably circular or substantially circular.

The laminate can be manufactured by laminating the support sheet-attached film-shaped firing material and the wafer so as to have a corresponding positional relationship.

As an embodiment of the present invention, a method of manufacturing a laminate is provided, the method including a step of affixing a film-shaped firing material to an inner circumferential section on a surface side of a wafer having an annular convex portion in an outer circumferential section, and through the method thereof, a laminate in which the support sheet, the film-shaped firing material, and the wafer are laminated in this order is obtained.

The support sheet-attached film-shaped firing material, the wafer, and the like, the positional relationship thereof, and the relationship of the size of each part, etc. can be exemplified by the above-described configuration indicated in the «Support sheet-attached film-shaped firing material» section.

As illustrated in Fig. 4, a laminate of the present embodiment can be provided in which the diameter D1 of the film-shaped firing material in the support sheet-attached film-shaped firing material 100 is less than or equal to the diameter D3 of the back surface inner circumferential section 16 of the wafer, and thereby even with a wafer 18 having the annular convex portion 17 in the outer circumferential section, the film-shaped firing material 1 can be appropriately affixed to the back surface inner circumferential section 16.

«Method of manufacturing a device»

Next, a method of using the support sheet-attached film-shaped firing material of the present embodiment is described using as an example, a case in which a semiconductor wafer is used as a wafer and the firing material is applied in the manufacturing of a semiconductor device.

As an embodiment of the present invention, a method of manufacturing a semiconductor device using a support sheet-attached film-shaped firing material is a method of manufacturing a semiconductor device using the support sheet-attached film-shaped firing material according to the present invention, the method including sequentially implementing the following steps (1) to (5).

Step (1): A step of cutting away the annular convex portion of the laminate according to the present embodiment;
Step (2): a step of dicing the wafer and the film-shaped firing material of the laminate from which the annular convex portion has been removed;
Step (3): a step of peeling apart the diced film-shaped firing material and the support sheet to obtain a film-shaped firing material-attached chip;
Step (4): a step of affixing the film-shaped firing material of the film-shaped firing material-attached chip to a front surface of a substrate; and
Step (5): a step of firing the film-shaped firing material of the film-shaped firing material-attached chip, and bonding the chip and the substrate.

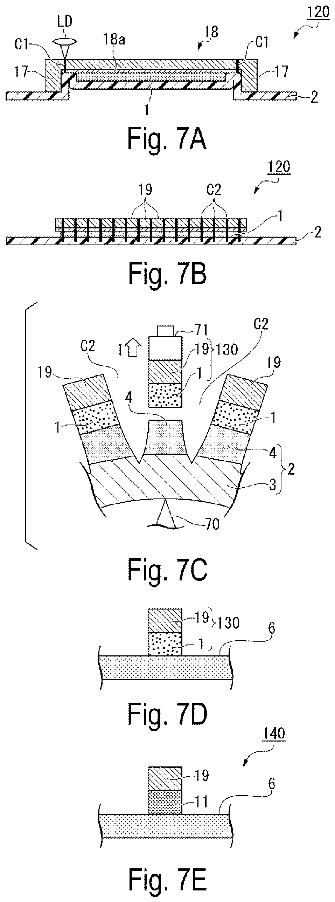

The above-mentioned steps (1) to (5) of the method for manufacturing a semiconductor device are described below with reference to Fig. 7.

• Step (1)

In step (1), a laminate 120 is used, the laminate 120 being obtained by, as illustrated in Fig. 7A, affixing a film-shaped firing material 1 of a support sheet-attached film-shaped firing material to a semiconductor wafer 18, and laminating a support sheet 2, the film-shaped firing material 1, and the semiconductor wafer 18 in this order.

Next, the annular convex portion is cut away. The annular convex portion can be cut by a known method, and the method thereof is not particularly limited.

For example, the annular convex portion can be cut away a method used to cut wafers, such as a method using a blade or a method of cutting by laser irradiation, and the method of cutting by laser irradiation is preferable.

The light ray wavelength of the laser irradiation is exemplified by a below-described case in which dicing is implemented by laser irradiation, and any wavelength of light that can be used to cut away the annular convex portion can be used.

The intensity and illuminance of the laser beam depends on the thickness of the wafer to be cut, but any intensity and illuminance at which the wafer can be fully cut is sufficient.

Here, as illustrated in Fig. 7A, an example is illustrated of a case in which a laser beam (illustrated as LD) is irradiated from the semiconductor wafer 18 side, and the annular convex portion 17 of the semiconductor wafer 18 of the laminate 120 is cut away. In the cutting, the annular convex portion 17 is cut away by forming a cut C1. The cut C1 is not formed in the support sheet 2 (the pressure sensitive adhesive layer 4 and the base material film 3), or does not affect a subsequent step even if formed.

When the annular convex portion is cut away by laser irradiation, in the support sheet-attached film-shaped firing material according to the present embodiment, the absorbance of the support sheet at the light beam wavelength of the laser irradiation is preferably not greater than 0.22, more preferably from 0 to 0.2, and even more preferably from 0 to 0.18. The absorbance of the support sheet at a wavelength of 355 nm is preferably 0.22 or less, more preferably from 0 to 0.2, and even more preferably from 0 to 0.18. The step of cutting away the annular convex portion is often implemented using a laser having a wavelength of 355 nm, and when a support sheet has the above configuration, breakage of the support sheet when processing with a laser can be prevented.

In the support sheet-attached film-shaped firing material according to the present embodiment, the load of the support sheet when elongated by 5% may be from 2 N/15 mm to 13 N/15 mm, may be from 3 N/15 mm to 10 N/15 mm, or may be from 4 N/15 mm to 9 N/15 mm. With a support sheet-attached film-shaped firing material for which the load of the support sheet when elongated by 5% is less than or equal to the upper limit described above, damage to the wafer in the step of cutting away the annular convex portion is effectively prevented. In addition, when the load at 5% elongation is greater than or equal to the lower limit described above, the wafer is reinforced in the step of cutting away the annular convex portion and in the dicing step, and wafer damage can be more effectively prevented.

• Step (2)

Step (2) is a step of dicing the wafer and the film-shaped firing material of the laminate from which the annular convex portion has been removed.

Dicing of the semiconductor wafer is not particularly limited and can be implemented by a known method.

For example, a semiconductor wafer can be diced by a method of cutting the semiconductor wafer, such as a method of using a blade (i.e., blade dicing), a method of dicing through laser irradiation (i.e., laser dicing), and a method of dicing by spraying water containing an abrasive (i.e., water dicing).

Here, as illustrated in Fig. 7B, a case is exemplified in which the semiconductor wafer 18 and the film-shaped firing material 1 of the laminate 120 are diced from the semiconductor wafer 18 side using a dicing blade. In this case, dicing is implemented by forming cuts C2 to thereby cut both the semiconductor wafer 18 and the film-shaped firing material 1, divide the semiconductor wafer, and form a semiconductor chip 19. Each cut C2 preferably reaches the pressure sensitive adhesive layer 4, but is not required to reach the base material film 3.

Note that when a semiconductor wafer having a circuit formed on a surface is diced into individual pieces (chips), the individual pieces are also referred to, in particular, as elements or semiconductor elements.

In blade dicing, the rotational speed of the dicing blade is preferably from 10000 to 60000 rpm, and more preferably from 20000 to 50000 rpm.

In addition, the movement speed of the dicing blade is preferably from 5 to 100 mm/s, and more preferably from 20 to 60 mm/s.

Furthermore, when the dicing blade is operated, cutting water is preferably flowed at a rate of approximately 0.5 to 1.5 L/min, for example, to the location where dicing is being implemented.

Although not illustrated, the semiconductor wafer 18 and the film-shaped firing material 1 of the laminate 120 can be laser diced by irradiating with a laser beam from the semiconductor wafer 18 side.

In laser dicing, the wavelength of the light beam irradiated onto the laminate may be any wavelength in a wavelength range from 300 to 1200 nm, may be any wavelength in a wavelength range from 320 to 600 nm, may be any wavelength from 325 to 540 nm, or may be any wavelength from 330 to 400 nm. Any wavelength in a wavelength range from 300 to 1200 nm may be any wavelength corresponding to a wavelength from 300 to 1200 nm, and more specifically, examples include wavelengths of 355 nm, 532 nm, and 1064 nm. These specific wavelengths are the laser wavelengths of lasers mounted in existing laser dicers, but in the present embodiment, light rays of any wavelength that can be used for dicing, the wavelengths thereof being in a wavelength range from 300 to 1200 nm, can be used.

A laser beam is typically used as the light beam, and while the intensity and illuminance of the laser beam depend on the thickness of the film-shaped firing material and wafer to be cut, an intensity and illuminance at which the wafer can be fully cut is sufficient.

The combination of the cutting away of the annular convex portion in step (1) and the dicing method in step (2) is optional, and for example, any of the following combinations may be employed.

A combination of Step (1): laser cutting and Step (2): laser dicing,

a combination of Step (1): blade cutting and Step (2): laser dicing,
a combination of Step (1): laser cutting and step (2): blade dicing, and
a combination of Step (1): blade cutting and Step (2): blade dicing.

Cutting with a laser is preferable because processing can be implemented at a high speed with respect to a thinned wafer.

• Step (3)

In step (3), the diced film-shaped firing material 1 and the support sheet 2 are peeled apart, and a film-shaped firing material-attached chip 130 is obtained.

As illustrated in Fig. 7C, a force can be applied from the base material film 3 side to the laminate 120 after the cuts C2 have been formed, and the semiconductor chip 19 can be pulled apart (picked up) from the pressure sensitive adhesive layer 4 of the support sheet together with the diced film-shaped firing material 1 to obtain a film-shaped firing material-attached chip 130.

Here, as one embodiment, a film-shaped firing material-attached chip 130 provided with the chip 19 and the film-shaped firing material 1 can be manufactured.

Fig. 7C illustrates an example in which a protuberance (pin) 70 is projected from a raised portion (not illustrated) of a device for manufacturing semiconductor devices, a tip end of the protuberance 70 pushes the laminate 120 upward from the base material film 3 side, and thereby a force is applied in the projection direction of the protuberance 70 to the laminate 120 after the cuts C2 and the semiconductor chip 19 have been formed. At this time, push-up conditions such as the projection amount (push-up amount) of the protuberance 70, the projection speed (push-up speed), and the holding time (push-up wait time) in the projected state can be adjusted as appropriate. The number of protuberances 70 is not particularly limited, and may be selected as appropriate.

Fig. 7C illustrates an example in which the semiconductor chip 19 is pulled upward by a pull-up portion 71 of the device for manufacturing a semiconductor device, and thereby the semiconductor chip 19 is peeled apart together with the film-shaped firing material 1 from the pressure sensitive adhesive layer 4. Here, the pull-up direction of the semiconductor chip 19 is indicated by an arrow I.

Note that in the picking up of the semiconductor chip 19, the method of raising the laminate 120 may be a well-known method, and examples include, in addition to a method of raising up using a protuberance like that describe above, a method of raising the laminate 120 by moving a slider along the laminate 120.

Note that the method of pulling up the semiconductor chip 19 may be a well-known method, and examples thereof include a method in which the front surface of the semiconductor chip 19 is suctioned and pulled up by a vacuum collet.

Also, when the pressure sensitive adhesive layer 4 is curable such as being energy ray-curable, the pressure sensitive adhesive layer 4 can be cured by energy ray irradiation or the like after dicing and before peeling apart (picking up) the film-shaped firing material 1 and the support sheet 2, and thereby the pressure sensitive adhesive force of the pressure sensitive adhesive layer 4 can be reduced. As a result, scattering of the chip during dicing is prevented by a high pressure sensitive adhesive force, and then at the time of picking up, the pressure sensitive adhesive force is reduced by curing, and the film-shaped firing material 1 and the support sheet 2 can be more easily peeled apart (picked up).

• Step (4)

Next, in step (4), as illustrated in Fig. 7D, the film-shaped firing material 1 of the film-shaped firing material-attached chip 130 is affixed to the front surface of a substrate 6. Through this, the chip 19 is affixed to the substrate 6 via the film-shaped firing material 1. The substrate 6 also includes a lead frame, a heat sink, or the like. According to the support sheet-attached film-shaped firing material of the present embodiment, exertion of a pressure sensitive adhesive force is also anticipated between the film-shaped firing material and the substrate. Thus, even in a state in which the chip and the substrate are temporarily fixed by the film-shaped firing material before firing, shifting of the chip position such as when being conveyed can be suppressed.

• Step (5)

Next, in step (5), the film-shaped firing material is fired, and the chip 19 and the substrate 6 are sintered and bonded (Fig. 7E). The exposed surface of the film-shaped firing material 1 of the film-shaped firing material-attached chip 130 is affixed to the substrate 6, and the substrate 6 and the chip 19 can be sintered and bonded together through the film-shaped firing material 1. Through firing, the sinterable metal particles in the film-shaped firing material 1 are melted and bonded to form a sintered body 11, and the chip 19 and the substrate 6 are sintered and bonded to obtain a semiconductor device 140.

The heating temperature at which the film-shaped firing material is fired may be set, as appropriate, in consideration of details such as the type of the film-shaped firing material, but the heating temperature is preferably from 100 to 600°C, more preferably from 150 to 550°C, and even more preferably from 200 to 400°C. The heating time may be set, as appropriate, in consideration of details such as the type of the film-shaped firing material, but the heating time is preferably from 5 seconds to 60 minutes, more preferably from 5 seconds to 30 minutes, and even more preferably from 10 seconds to 10 minutes.

The film-shaped firing material may be fired through pressurized firing in which the film-shaped firing material is fired while applying pressure thereto. The pressurization conditions can be approximately, for example, from 5 to 15 MPa.

Note that in the embodiment described above, a case was exemplified in which the chip of the film-shaped firing material and the substrate thereof were sintered and bonded, but the target for sintering and bonding with the film-shaped firing material is not limited to the case exemplified above, and sintering and bonding can be implemented with various articles that are sintered in contact with the film-shaped firing material.

Furthermore, in the embodiment described above, the film-shaped firing material can be processed into the same shape as a chip by using a blade or the like to form the film-shaped firing material into individual pieces together with the semiconductor wafer, and thereby a film-shaped firing material-attached chip can be manufactured. In other words, in the film-shaped firing material-attached chip, the size (surface area) of the contact surface of the film-shaped firing material and the size (surface area) of the contact surface of the chip are the same, but these may be different. For example, the substrate and the chip may be pasted together through the film-shaped firing material in a state in which the contact surface of the film-shaped firing material is larger than the contact surface of the chip. Specifically, a film-shaped firing material of a desired size may be disposed on a substrate, and a chip having a smaller contact surface than the film-shaped firing material may be affixed to the film-shaped firing material.

According to the method for manufacturing a device of the present embodiment, a device can be manufactured with high efficiency by using a support sheet-attached film-shaped firing material having excellent dicing suitability.

Examples

The present invention is described in further detail below through the presentation of examples, but the present invention is not limited by these examples.

Example 1

<Manufacturing of a support sheet>

(Manufacturing of a pressure sensitive adhesive composition)

A non-energy ray-curable pressure sensitive adhesive composition having a solid content concentration of 30 mass% was manufactured, the non-energy ray-curable pressure sensitive adhesive composition containing 100 parts by mass (solid content) of an acrylic polymer and 0.8 parts by mass (solid content) of a tolylene diisocyanate adduct ("Coronate L", available from Tosoh Corporation) of trimethylolpropane as a crosslinking agent, and further containing, as a solvent, a mixed solvent of methyl ethyl ketone, toluene, and ethyl acetate. The acrylic polymer was a copolymer having a methacryloyloxy group in a side chain and a weight average molecular weight of 600000, and was obtained by adding, to a copolymer obtained by copolymerizing 80 parts by mass of 2-ethylhexyl acrylate (2EHA) and 20 parts by mass of 2-hydroxyethyl acrylate (HEA), 2-methacryloyloxyethyl isocyanate (hereinafter, abbreviated as "MOI") at an amount such that the total number of moles of isocyanate groups in the MOI was 0.8 times the total number of moles of HEA-derived hydroxyl groups in the acrylic polymer.

(Manufacturing of a support sheet)

A release film ("SP-PET381031", available from Lintec Corporation, thickness of 38 $\mu$m) obtained by release treating one surface of a poly(ethylene terephthalate) film with a silicone treatment was used, the release-treated surface was coated with the pressure sensitive adhesive composition obtained above and heated and dried for two minutes at 120°C, and thereby an energy ray-curable pressure sensitive adhesive layer was formed. The pressure sensitive adhesive composition was coated onto the release-treated surface at this time with conditions set such that the thickness of the pressure sensitive adhesive layer after drying was 10 $\mu$m. As a base material film, a film made of polypropylene (PP) and having a thickness of 80 $\mu$m was affixed to an exposed surface of this pressure sensitive adhesive layer, and thereby a support sheet was obtained.

<Manufacturing of a firing material composition>

The components used in the manufacturing of a firing material composition are shown below. Here, metal particles having a particle diameter of not greater than 100 nm are expressed as "sinterable metal particles".

(Sinterable metal particle-containing paste material)

• Alconano Silver Paste ANP-4 (organic coated composite silver nanopaste available from Nanoparticle Laboratory Corporation: alcohol derivative coated silver particles; metal content of 80 mass% or higher; 25 mass% or more of silver particles (sinterable metal particles) having an average particle diameter of 100 nm or less)

(Binder component)

• Acrylic polymer 1 (2-ethylhexyl methacrylate polymer, mass average molecular weight: 260000, Tg: -10°C)
Note that the Tg of the acrylic polymer 1 is a calculated value obtained using the Fox equation.
A firing material composition was obtained by blending and mixing 86.8 parts by mass of the sinterable metal particle-containing paste material and 13.2 parts by mass of the binder component. The sinterable metal particle-containing paste material is sold containing a high boiling point solvent, and the solvent remains in the film-shaped firing material after coating or after drying. Therefore, the components of the sinterable metal particle-containing paste material are described including these components. The solvent in the binder component volatilizes upon drying, and in consideration thereof, the parts by mass of the solid content is expressed excluding the solvent component.

<Manufacturing of the film-shaped firing material>

The firing material composition obtained as described above was printed onto on one side of a 230 mm wide release film (thickness: 38 $\mu$m, SP-PET381031, available from Lintec Corporation) so as to have a coating diameter of 190 mm, and then dried for 10 minutes at 150°C, and thereby a film-shaped firing material with a thickness of 40 $\mu$m was obtained.

<Manufacturing of the support sheet-attached film-shaped firing material>

A film-shaped firing material printed in a circular shape with a diameter of 190 mm was affixed to the pressure sensitive adhesive layer surface of the support sheet described above (after peeling apart the release film), the support sheet was cut from the base material film side in a circular shape with a diameter of 270 mm, and a support sheet-attached film-shaped firing material was obtained with the circular film-shaped firing material and a release film laminated on the support sheet having the pressure sensitive adhesive layer on the base material film.
Table 1 shows the configuration of each portion.

Example 2

A support sheet-attached film-shaped firing material of Example 2 was obtained in the same manner as in Example 1 with the exception that the diameter of the film-shaped firing material was changed as shown in Table 1.

Example 3

A support sheet-attached film-shaped firing material of Example 3 was obtained in the same manner as in Example 1 with the exception that the base material film was changed to an ethylene-methacrylic acid copolymer (EMAA) film having a thickness of 60 $\mu$m.

Example 4

A support sheet-attached film-shaped firing material of Example 4 was obtained in the same manner as in Example 1 with the exception that the base material film was changed to a low density polyethylene (LDPE) film having a thickness of 80 $\mu$m.

Example 5

A support sheet-attached film-shaped firing material of Example 5 was obtained in the same manner as in Example 1 with the exception that the base material film was changed to a polyurethane (PU) film having a thickness of 100 $\mu$m.

Example 6

A support sheet-attached film-shaped firing material of Example 6 was obtained in the same manner as Example 1 with the exception that the acrylic polymer was changed to a copolymer having a weight average molecular weight of 600000 and obtained by copolymerizing 80 parts by mass of 2-ethylhexyl acrylate (2EHA) and 20 parts by mass of 2-hydroxyethyl acrylate (HEA), the amount of the crosslinking agent was changed as shown in Table 1, and the base material film was changed to a polyvinyl chloride (PVC) film having a thickness of 80 $\mu$m.

Example 7

A support sheet-attached film-shaped firing material of Example 7 was obtained in the same manner as in Example 1 with the exception that the base material film was changed to a polypropylene (PP) film having a thickness of 140 $\mu$m.

Example 8

A support sheet-attached film-shaped firing material of Example 8 was obtained in the same manner as in Example 6 with the exception that the base material film was changed to a poly(ethylene terephthalate) (PET) film having a thickness of 50 $\mu$m.

Example 9

A support sheet-attached film-shaped firing material of Example 9 was obtained in the same manner as in Example 6 with the exception that the base material film was changed to a polyimide (PI) film having a thickness of 50 $\mu$m.

Comparative Example 1

The film-shaped firing material (without the support sheet attached) produced in Example 1 was used. The diameter of the film-shaped firing material was changed as shown in Table 1, and the diameter of the film-shaped firing material was set so as to be greater than the diameter of the wafer back surface inner circumferential section.

Comparative Example 2

A support sheet-attached film-shaped firing material of Comparative Example 2 was obtained in the same manner as in Example 1 with the exception that the diameter of each portion was changed as shown in Table 1, and the diameter of the film-shaped firing material was set so as to be greater than the diameter of the wafer back surface inner circumferential section.

«Measurement and Evaluation»

(Measurement of load of support sheet when elongated by 5%)

The support sheet-attached film-shaped firing material obtained in each of the above examples and comparative examples was cut to a width of 15 mm and a length of 150 mm, and then used as a test piece. The release film was removed from the test piece, after which the test piece was set in a universal tester (Autograph AG-IS 500 N, available from Shimadzu Corporation) so that the distance between chucks was 100 mm, and measurements were performed at a speed of 200 mm/min in a 23°C, 50% RH environment. The load at 5% (i.e., 5 mm) elongation was read and used as the load at 5% elongation.

Note that when an energy ray-curable adhesive was used in the pressure sensitive adhesive layer (Examples 1 to 5, Example 7, and Comparative Example 2), the test piece was measured before being irradiated with energy rays.

(Measurement of the absorbance of the support sheet)

With regard to the support sheets obtained in each of the examples and comparative examples described above, light was incident from the base material film side of the support sheet, and the absorbance at a wavelength of 355 nm was measured using an ultraviolet-visible light-near infrared spectrophotometer (UV-3101 PC available from Shimadzu Corporation) in which integrating spheres were used as a detector.

(Evaluation of dicing suitability (affixing property, dicing, pick-up))

The support sheet-attached film-shaped firing material obtained in each of the above examples and comparative examples (film-shaped firing material in the case of Comparative Example 1) was tensioned in an SUS ring frame having an inner diameter of 250 mm under conditions of 23°C and 20 mm/s using the wafer mounter RAD-2500m/12 (available from Lintec Corporation).

Next, a vacuum wafer mounter RAD-2512m/12 (available from Lintec Corporation) was used to affix, under conditions including a table temperature of 90°C and a differential pressure of 0.2 kPa, the film-shaped firing material to an inner circumferential section (back surface inner circumferential section) of a surface side of a silicon wafer having an annular convex portion on the outer circumferential section, the surface side thereof having the annular convex portion, and the affixing property was evaluated. Subsequently, the following rim dicing and dicing were implemented, and the dicing suitability was evaluated.

The shape of the silicon wafer was as follows.

- Thickness of the inner circumferential section: 100 $\mu$m
- Thickness of the annular convex portion: 400 $\mu$m
- Wafer diameter: 200 mm
- Diameter of the wafer back surface inner circumferential section: 194.8 mm

[Affixing property (annular convex portion)]

The affixing property was determined to be A for cases in which the film-shaped firing material obtained in each of the examples and comparative examples described above could be affixed to the outer circumferential section (16a in Fig. 4) of the back surface inner circumferential section without damaging the film-shaped firing material, and was determined to be B for cases in which the film-shaped firing material could not be affixed.

[Affixing property (wafer)]

The affixing property was determined to be A for cases in which the film-shaped firing material obtained in each of the examples and comparative examples described above could be affixed to the back surface inner circumferential section (back surface inner circumferential section 16 and metal film 18a in Fig. 4) without damaging the film-shaped firing material, and was determined to be B for cases in which the film-shaped firing material could not be affixed.

[Rim Dicing (annular convex portion, blade)]

The annular convex portion of the outer circumferential section of the wafer was circle cut using a blade dicer DFD6361 (available from Disco Corporation) under the following conditions. For cases in which an energy ray-curable pressure sensitive adhesive was used in the pressure sensitive adhesive layer, only the outer circumferential section was irradiated with ultraviolet rays from the support sheet 2 side, and only the outer circumferential section of the cut wafer was peeled apart and removed from the support sheet.

- Blade thickness: 25 $\mu$m width (27HECC)
- Blade rpm: 30000 rpm
- Cutting conditions: Cutting was implemented such that the base material film was cut to a depth of 20 $\mu$m from the wafer side.
- Cutting speed: 5 deg/s
- Circle cut range: Wafer diameter of 6 mmcp
- Cutting water flow rate: 1.5 L/min
- Cutting water temperature: 24°C

Rim dicing was determined to be A in cases in which a circle cut could be made without damaging the wafer inner circumferential section, and was determined to be B for cases in which damage to the wafer inner circumferential section occurred.

[Rim dicing (annular convex portion, laser)]

The annular convex portion of the outer circumferential section of the wafer was circle cut using a laser dicer DFL7160 (available from Disco Corporation) under the following conditions. For cases in which an energy ray-curable pressure sensitive adhesive was used in the pressure sensitive adhesive layer, only the outer circumferential section was irradiated with ultraviolet rays from the support sheet 2 side, and only the outer circumferential section of the cut wafer was peeled apart and removed from the support sheet.

- Circle cut range: Wafer diameter of 6 mmcp
- Laser wavelength: 355 nm
- Cutting speed: 40 deg/s

Rim dicing was determined to be A for cases in which a circle cut could be made without damaging the wafer inner circumferential section and without the occurrence of full breakage of the support sheet, and was determined to be B for cases in which the wafer inner circumferential section was damaged or full breakage of the support sheet occurred.

[Dicing (chip, blade)]

Dicing was implemented using a blade dicer DFD6362 (available from Disco Corporation) under the following conditions.

- Dicing condition: Implemented such that each chip had a size of 5 mm × 5 mm.
- Blade thickness: 25 $\mu$m width (27HECC)
- Blade rpm: 30000 rpm
- Cutting conditions: Cutting was implemented such that the base material film was cut to a depth of 20 $\mu$m from the film-shaped firing material side.
- Cutting speed: 30 mm/s
- Cutting range: Wafer diameter + 20 mm$\varphi$
- Cutting water flow rate: 1.5 L/min
- Cutting water temperature: 24°C

The dicing was determined to be A for cases in which the wafer and the film-shaped firing material could be diced, and was determined to be B for cases in which the wafer and film-shaped firing material could not be diced.

[Dicing (chip, laser)]

Dicing was implemented using a laser dicer DFL7160 (available from Disco Corporation) under the following conditions.

- Dicing condition: Implemented such that each chip had a size of 5 mm × 5 mm.
- Laser wavelength: 355 nm
- Cutting speed: 100 mm/s

The dicing was determined to be A for cases in which the wafer and the film-shaped firing material could be fully diced without damaging the support sheet in any manner, and was determined to be B for cases in which full breakage of the support sheet occurred.

[Pick-up]

When an energy ray-curable pressure sensitive adhesive was used in the pressure sensitive adhesive layer, irradiation was implemented with ultraviolet rays from the support sheet 2 side, and five chips, each having a size of 5 mm × 5 mm and obtained by the dicing described above, were consecutively picked up using a die bonder (BESTEM D02, available from Canon Machinery Inc.) under conditions including a needle height of 0.3 mm and a pick-up speed of 5 mm/s.

The pick-up property was determined to be A for cases in which the five chips could be picked up without any problems.

For the ultraviolet light irradiation described above, the Adwill RAD2000m/12 was used to irradiate from the support sheet 2 side at a main wavelength of 365 nm under conditions including 200 mW/cm$^2$ and 200 mJ/cm$^2$, and through this, the pressure sensitive adhesive layer was UV cured.

The above evaluation results are shown in Table 1 below.

Table 1

| Configuration | | | | | Examples | | | | | | | | | Comparative Examples | |
|---|---|---|---|---|---|---|---|---|---|---|---|---|---|---|---|---|
| | | | | | 1 | 2 | 3 | 4 | 5 | 6 | 7 | 8 | 9 | 1 | 2 |
| | Diameter (mm) | | Wafer back surface inner circumferential section | | 194.8 | 194.8 | 194.8 | 194.8 | 194.8 | 194.8 | 194.8 | 194.8 | 194.8 | 194.8 | 194.8 |
| | | | Film-shaped firing material | | 190 | 192 | 190 | 190 | 190 | 190 | 190 | 190 | 190 | 270 | 270 |
| | | | Support sheet | | 270 | 270 | 270 | 270 | 270 | 270 | 270 | 270 | 270 | - | 270 |
| | Support sheet | Pressure sensitive adhesive layer | Acrylic polymer [Mass%] *1 | 2EHA | 80 | 80 | 80 | 80 | 80 | 80 | 80 | 80 | 80 | - | 80 |
| | | | | HEA | 20 | 20 | 20 | 20 | 20 | 20 | 20 | 20 | 20 | - | 20 |
| | | | UV curing component *2 | MOI | 80% | 80% | 80% | 80% | 80% | - | 80% | - | - | - | 80% |
| | | | Crosslinking agent [parts by mass] *3 | | 0.8 | 0.8 | 0.8 | 0.8 | 0.8 | 8 | 0.8 | 8 | 8 | - | 0.8 |
| | | | Curability of pressure sensitive adhesive material layer | | UV | UV | UV | UV | UV | - | UV | - | - | - | UV |
| | | Base material | Material | | PP | PP | EMAA | LDPE | PU | PVC | PP | PET | PI | - | EMAA |
| | | | Thickness (μm) | | 80 | 80 | 60 | 80 | 100 | 80 | 140 | 50 | 50 | - | 80 |
| | | Tension [N/15 mm] at 5% elongation | | | 8.7 | 8.7 | 4.4 | 6.0 | 7.5 | 9.5 | 15 | 62 | 186 | - | 5.8 |

EP 3 979 300 A1

| | | | | | | | | | | | | | | |
|---|---|---|---|---|---|---|---|---|---|---|---|---|---|---|
| | | Absorbance | | 0.05 | 0.05 | 0.03 | 0.04 | 0.17 | 0.52 | 0.05 | 0.08 | 4 | - | 0.03 |
| Evaluation | Affixing property | Annular convex portion | | A | A | A | A | A | A | B *6 | B *6 | B *6 | B *4 | B *4 |
| | | Wafer | | A | A | A | A | A | A | A | A | A | B *4, 5 | B *5 |
| | Dicing | Annular convex portion | Blade | A | A | A | A | A | A | B | B | B | - | - |
| | | | Laser | A | A | A | A | A | B | B | B | B | - | - |
| | | Chip | Blade | A | A | A | A | A | A | A | A | A | - | - |
| | | | Laser | A | A | A | A | A | B | A | A | B | - | - |
| | Pick-up | | | A | A | A | A | A | A | A | A | A | - | - |

*1: Indicates the content percentage [mass%] of each monomer (solid content) in a total of 100 mass% of the raw material monomers (solid content) of the acrylic polymer.
*2: Indicates a percentage of the total number of moles of isocyanate groups in MOI relative to 100% of the total number of moles of HEA-derived hydroxyl groups.
*3: Indicates the added amount (parts by mass) of the crosslinking agent per 100 parts by mass of the acrylic polymer (solid content).
*4: Damage to the film-shaped firing material
*5: Affixing of the film-shaped firing material was non-uniform.
*6: Problems with affixing to the outer circumferential section 16a of the back surface inner circumferential section.

**EP 3 979 300 A1**

In Examples 1 to 9, which satisfy the stipulation that the diameter of the film-shaped firing material be less than or equal to the diameter of the back surface inner circumferential section of the wafer, as indicated in the evaluation item of the affixing property (wafer) in Table 1, it is clear that in comparison to Comparative Examples 1 and 2, which do not satisfy the above-mentioned stipulation, the film-shaped firing materials could be affixed uniformly to the back surface inner circumferential section of the wafer without damaging the film-shaped firing materials. In Comparative Examples 1 and 2, the diameter of the film-shaped firing material was larger than the diameter of the back surface inner circumferential section of the wafer, and therefore damage to the film-shaped firing materials and uneven affixing were observed when the film-shaped firing materials were applied to a wafer. Furthermore, Comparative Example 1 was not provided with a support sheet, and therefore the firing material was directly fixed to the ring frame, and it was difficult to uniformly affix the film-shaped firing material to the wafer without damaging the film-shaped firing material.

With the support sheet-attached film-shaped firing materials of Examples 1 to 6 in which the load of the support sheet when elongated by 5% was 13 N/15 mm or less, the property of affixing to the boundary between the inner side surface 12 of the annular convex portion and the back surface inner circumferential section 16 was favorable, damage to the wafer inner circumferential section when dicing the annular convex portion did not occur, and the evaluation results of the items regarding dicing (annular convex portion) were favorable.

Note that from the evaluation results of the dicing (laser) items in Examples 6 and 9, it is clear that if laser dicing at a wavelength of 355 nm is adopted for the dicing, the absorbance of the support sheet at 355 nm is preferably 0.22 or less in order to prevent breakage of the support sheet.

Each configuration in each of the embodiments and the combinations thereof are merely examples, and additions, omissions, substitutions, and other changes may be made to the configuration within a range that does not depart from the spirit of the present invention. The present invention is also not limited by each of the embodiments and is limited only by the scope of the claims.

[Reference Signs List]

| | |
|---|---|
| 1: | Film-shaped firing material |
| 2: | Support sheet |
| 3: | Base material film |
| 4: | Pressure sensitive adhesive layer |
| 5: | Ring frame |
| 6: | Substrate |
| 10: | Sinterable metal particles |
| 11: | Sintered body |
| 12: | Inner side surface of annular convex portion |
| 13: | Circuit |
| 14: | Front surface inner circumferential section |
| 15: | Surplus portion |
| 16: | Back surface inner circumferential section |
| 16a: | Outer circumferential section of back surface inner circumferential section |
| 17: | Annular convex portion |
| 18: | Wafer |
| 18a: | Metal film |
| 19: | Chip |
| 20: | Binder component |
| 30: | Release film |
| 70: | Protuberance |
| 71: | Pull-up portion |
| 100: | Support sheet-attached film-shaped firing material |
| 110: | Roll body |
| 120: | Laminate |
| 130: | Film-shaped firing material-attached chip |
| 140: | Device |
| D1: | Diameter of the film-shaped firing material |
| D2: | Diameter of support sheet |
| D3: | Diameter of back surface inner circumferential section |
| D4: | Diameter of wafer |

P:          Unit
C1, C2:     Cut
LD:         Laser beam irradiation

**Claims**

1.  A support sheet-attached film-shaped firing material comprising a support sheet having a pressure sensitive adhesive layer on a base material film, and a film-shaped firing material provided on the pressure sensitive adhesive layer, wherein

    the support sheet-attached film-shaped firing material is used to affix the film-shaped firing material to an inner circumferential section on a surface side of a wafer having an annular convex portion on an outer circumferential section, the surface side thereof having the annular convex portion, and
    a diameter of the film-shaped firing material is less than or equal to a diameter of the inner circumferential section of the wafer.

2.  A support sheet-attached film-shaped firing material comprising a support sheet having a pressure sensitive adhesive layer on a base material film, and a film-shaped firing material provided on the pressure sensitive adhesive layer, wherein
    a diameter of the film-shaped firing material is from 130 to 146 mm, from 180 to 196 mm, from 280 to 296 mm, or from 430 to 446 mm.

3.  The support sheet-attached film-shaped firing material according to claim 1 or 2, wherein

    a thickness of the support sheet is 120 $\mu$m or less, and
    a load of the support sheet when elongated by 5% is 13 N/15 mm or less as measured by the following measurement method:
    measurement method: a test piece is obtained by cutting the support sheet to a width of 15 mm and a length of 150 mm (provided that for a case in which the pressure sensitive adhesive layer is curable, the test piece is obtained prior to curing), the test piece is drawn in a 23°C, 50% RH environment under conditions including a distance between chucks of 100 mm and a tensile speed of 200 mm/min, and the load with respect to a displacement amount is measured.

4.  The support sheet-attached film-shaped firing material according to any one of claims 1 to 3, wherein the support sheet has an absorbance at a wavelength of 355 nm of 0.22 or less.

5.  The support sheet-attached film-shaped firing material according to any one of claims 1 to 4, wherein the pressure sensitive adhesive layer is energy ray-curable.

6.  The support sheet-attached film-shaped firing material according to claim 5, wherein the pressure sensitive adhesive layer comprises a pressure sensitive adhesive resin, and the pressure sensitive adhesive resin has an energy ray-polymerizable unsaturated group in a side chain thereof.

7.  The support sheet-attached film-shaped firing material according to any one of claims 1 to 6, wherein the pressure sensitive adhesive layer comprises a pressure sensitive adhesive resin, and the pressure sensitive adhesive resin includes a constituent unit derived from a (meth)acrylate having in a side chain an alkoxy group having from 8 to 18 carbons.

8.  The support sheet-attached film-shaped firing material according to any one of claims 1 to 7, wherein a thickness of the film-shaped firing material before firing is from 10 to 200 $\mu$m.

9.  A roll body in which the support sheet-attached film-shaped firing material described in any one of claims 1 to 8 is laminated on a long release film with the film-shaped firing material being oriented inward, and
    the release film and the support sheet-attached film-shaped firing material are wound into a roll.

10. A laminate obtained by affixing the support sheet-attached film-shaped firing material described in any one of claims 1 to 8 to an inner circumferential section on a surface side of a wafer having an annular convex portion in an outer circumferential section, the surface side thereof having the annular convex portion, and laminating the support sheet, the film-shaped firing material, and the wafer in this order.

**11.** A method for manufacturing a device by sequentially implementing steps (1) to (5):

step (1): cutting away the annular convex portion of the laminate described in claim 10;

step (2): dicing the wafer and the film-shaped firing material of the laminate from which the annular convex portion has been removed;

step (3): peeling apart the diced film-shaped firing material and the support sheet to obtain a film-shaped firing material-attached chip;

step (4): affixing the film-shaped firing material of the film-shaped firing material-attached chip to a front surface of a substrate; and

step (5): firing the film-shaped firing material of the film-shaped firing material-attached chip, and bonding the chip and the substrate.

Fig. 1

Fig. 2

BACK SURFACE

FRONT SURFACE

**Fig. 3**

**Fig. 4**

**Fig. 5**

Fig. 6

EP 3 979 300 A1

Fig. 7A

Fig. 7B

Fig. 7C

Fig. 7D

Fig. 7E

<center>**INTERNATIONAL SEARCH REPORT**</center>

| International application No. |
|---|
| PCT/JP2020/019910 |

**A.    CLASSIFICATION OF SUBJECT MATTER**
H01L 21/301(2006.01)i
FI: H01L21/78 M
According to International Patent Classification (IPC) or to both national classification and IPC

**B.    FIELDS SEARCHED**

Minimum documentation searched (classification system followed by classification symbols)
H01L21/301

| Documentation searched other than minimum documentation to the extent that such documents are included in the fields searched | |
|---|---|
| Published examined utility model applications of Japan | 1922–1996 |
| Published unexamined utility model applications of Japan | 1971–2020 |
| Registered utility model specifications of Japan | 1996–2020 |
| Published registered utility model applications of Japan | 1994–2020 |

Electronic data base consulted during the international search (name of data base and, where practicable, search terms used)

**C.    DOCUMENTS CONSIDERED TO BE RELEVANT**

| Category* | Citation of document, with indication, where appropriate, of the relevant passages | Relevant to claim No. |
|---|---|---|
| Y | JP 2016-018877 A (MITSUBISHI ELECTRIC CORP.) 01.02.2016 (2016-02-01) paragraphs [0002]-[0200], fig. 1-22 | 1, 2, 4-11 |
| A | paragraphs [0002]-[0200], fig. 1-22 | 3 |
| Y | WO 2019/054237 A1 (LINTEC CORP.) 21.03.2019 (2019-03-21) paragraphs [0002]-[0157], fig. 1-6 | 1, 2, 4-11 |
| A | paragraphs [0002]-[0157], fig. 1-63 | 3 |
| Y | JP 2017-125093 A (SEKISUI CHEMICAL CO., LTD.) 20.07.2017 (2017-07-20) paragraphs [0007]-[0009] | 4, 6, 7 |
| A | paragraphs [0007]-[0009] | 3 |
| Y | JP 2018-171864 A (LINTEC CORP.) 08.11.2018 (2018-11-08) paragraphs [0146], [0160] | 6, 7 |
| A | paragraphs [0146], [0160] | 3 |
| Y | WO 2017/170021 A1 (LINTEC CORP.) 05.10.2017 (2017-10-05) paragraph [0105] | 7 |
| A | paragraph [0105] | 3 |

☒    Further documents are listed in the continuation of Box C.        ☒    See patent family annex.

| | |
|---|---|
| *        Special categories of cited documents: | "T"    later document published after the international filing date or priority date and not in conflict with the application but cited to understand the principle or theory underlying the invention |
| "A"    document defining the general state of the art which is not considered to be of particular relevance | |
| "E"    earlier application or patent but published on or after the international filing date | "X"    document of particular relevance; the claimed invention cannot be considered novel or cannot be considered to involve an inventive step when the document is taken alone |
| "L"    document which may throw doubts on priority claim(s) or which is cited to establish the publication date of another citation or other special reason (as specified) | "Y"    document of particular relevance; the claimed invention cannot be considered to involve an inventive step when the document is combined with one or more other such documents, such combination being obvious to a person skilled in the art |
| "O"    document referring to an oral disclosure, use, exhibition or other means | |
| "P"    document published prior to the international filing date but later than the priority date claimed | "&"    document member of the same patent family |

| Date of the actual completion of the international search | Date of mailing of the international search report |
|---|---|
| 12 June 2020 (12.06.2020) | 23 June 2020 (23.06.2020) |

| Name and mailing address of the ISA/ | Authorized officer |
|---|---|
| Japan Patent Office 3-4-3, Kasumigaseki, Chiyoda-ku, Tokyo 100-8915, Japan | Telephone No. |

Form PCT/ISA/210 (second sheet) (January 2015)

<center>46</center>

**INTERNATIONAL SEARCH REPORT**

International application No.

PCT/JP2020/019910

C (Continuation). DOCUMENTS CONSIDERED TO BE RELEVANT

| Category* | Citation of document, with indication, where appropriate, of the relevant passages | Relevant to claim No. |
|---|---|---|
| A | JP 2012-216625 A (LINTEC CORP.) 08.11.2012 (2012-11-08) entire text, all drawings | 1-11 |

Form PCT/ISA/210 (continuation of second sheet) (January 2015)

**INTERNATIONAL SEARCH REPORT**
Information on patent family members

International application No.

PCT/JP2020/019910

| Patent Documents referred in the Report | Publication Date | Patent Family | Publication Date |
|---|---|---|---|
| JP 2016-018877 A | 01 Feb. 2016 | (Family: none) | |
| WO 2019/054237 A1 | 21 Mar. 2019 | TW 201919796 A | |
| JP 2017-125093 A | 20 Jul. 2017 | (Family: none) | |
| JP 2018-171864 A | 08 Nov. 2018 | (Family: none) | |
| WO 2017/170021 A1 | 05 Oct. 2017 | KR 10-2018-0127984 A<br>CN 109005665 A<br>TW 201802903 A | |
| JP 2012-216625 A | 08 Nov. 2012 | (Family: none) | |

Form PCT/ISA/210 (patent family annex) (January 2015)

**REFERENCES CITED IN THE DESCRIPTION**

**Patent documents cited in the description**

- JP 2019097544 A
- JP 2014111800 A
- JP 2007019379 A
- JP 2007266352 A
- JP 2007287796 A